# EUROPÄISCHE PATENTANMELDUNG

(11) **EP 4 835 866 A2**
(43) Veröffentlichungstag der Anmeldung: **04.11.2026**
(21) Anmeldenummer: 26204934.9
(22) Anmeldetag: 09.03.2021
(51) Int. Cl.: G09F 3/20

(54) **TRAGEVORRICHTUNG, INSBESONDERE REGALSCHIENE, ZUM TRAGEN EINES ELEKTRONISCHEN GERÄTS, BEVORZUGT EINER ELEKTRONISCHEN ANZEIGEEINHEIT**

(62) Dokumentnummer(n) der früheren Anmeldung(en) nach Art. 76 EPÜ: 21712729.9 / 4 305 614
(71) Anmelder: VusionGroup GmbH, 8072 Fernitz-Mellach (AT)
(72) Erfinder: RÖSSL, Andreas, 8072 FERNITZ-MELLACH (AT)
(74) Vertreter: Plasseraud IP

(57) **Zusammenfassung**

Tragevorrichtung für die mechanische Befestigung einer elektronischen Anzeigeeinheit, wobei die Tragevorrichtung aufweist: eine erste Begrenzungswand an der die elektronische Anzeigeeinheit an der Tragevorrichtung positionierbar ist, eine in einem Winkel zu der ersten Begrenzungswand orientierte zweite Begrenzungswand, wobei die erste Begrenzungswand und die zweite Begrenzungswand einen Aufnahmebereich für die Aufnahme der elektronischen Anzeigeeinheit begrenzen, und einen Leitungsträger, der Leitungsbahnen zur elektronischen Versorgung der elektronischen Anzeigeeinheit trägt, wobei der Leitungsträger in einem Abstand von der ersten Begrenzungswand ausgehend von der zweiten Begrenzungswand in den Aufnahmebereich hineinragt.

## Beschreibung

### Technisches Feld

Die Erfindung betrifft eine Tragevorrichtung, insbesondere Regalschiene, zum Tragen eines elektronischen Geräts, bevorzugt einer elektronischen Anzeigeeinheit, wobei die Tragevorrichtung begrenzungswände zum Begrenzen eines Aufnahmebereichs zur Aufnahme des elektronischen Geräts aufweist.

### Hintergrund

Die WO 2017/153481 A1 offenbart eine Tragevorrichtung in Form einer Regalschiene, die zur mechanischen Befestigung eines elektronischen Geräts realisiert als eine elektronische Anzeigeeinheit ausgebildet ist. Die Regalschiene begrenzt einen Aufnahmebereich zum Aufnehmen der Anzeigeeinheit mit drei in U-Form angeordneten Seitenwänden. Der Aufnahmebereich ist hier also dreiseitig begrenzt und die Anzeigeeinheit lässt sich über die freigelassene Seite der U-Form in die Regalschiene einsetzen bzw. von dort entnehmen.

Eine erste, zentrale Seitenwand ist durch eine Platte gebildet. Diese Platte dient als Referenz.- bzw. Positionierung-Ebene, an der die Anzeigeeinheit mit ihrer Rückwand an der Regalschiene positionierbar ist. Die Platte weist im Raster angeordnete Durchlässe auf. Diese Durchlässe dienen zur Kontaktierung von elektrischen Leiterbahnen durch Kontakt-Pins der Anzeigeeinheit, um die Anzeigeeinheit elektrisch zu versorgen. Die Leiterbahnen sind auf einem Leitungsträger angeordnet, der an jener von dem Aufnahmebereich abgewandten Seite der ersten Seitenwand positioniert ist.

In Längsrichtung der Regalschiene betrachtet ist die erste Seitenwand durch eine zweite, obere Seitenwand, und eine dritte, untere Seitenwand begrenzt.

Die untere Seitenwand weist eine in Längsrichtung der Regalschiene verlaufende Befestigungskante auf, die von einer Befestigungsnut der Anzeigeeinrichtung umgriffen werden kann.

Die obere Seitenwand weist in Längsrichtung der Regalschiene im Raster angeordnete lochartige Aussparungen auf, in die ein ein- und ausfahrbarer Befestigungsstift der Anzeigeeinrichtung einrasten kann, wodurch die Position der Anzeigevorrichtung entlang der Regalschiene fixierbar ist.

Diese Regalschiene hat sich im Betrieb ausgezeichnet bewährt, weil sie eine präzise Positionierung der Anzeigeeinrichtung entlang der Regalschiene gemäß dem Raster der lochartigen Aussparungen erlaubt und durch die zweite und die dritte Seitenwand in Kombination mit dem ausgefahrenen und in der oberen Seitenwand eingerasteten Stift ein unbeabsichtigtes Verschieben, ja sogar unbeabsichtigtes oder auch mutwilliges Entfernen der Anzeigeeinheit von der Regalschiene ohne zerstörerische Krafteinwirkung weitestgehend unmöglich macht.

Allerdings hat sich die Pflege der Regalschiene als problematisch erwiesen, weil sich in der durch die untere Seitenwand zwischen der zentralen Platte und der Befestigungskante gebildeten Rinne wie auch in den Durchlässen der zentralen Platte hin zu den Leitungsbahnen Verunreinigungen ablagern können. Diese Verunreinigungen haben einerseits einen negativen Einfluss auf die optische Erscheinung der Regalschiene. Anderseits können sie auch die elektrische Versorgung der Anzeigeeinheit und somit deren Funktionszuverlässigkeit beeinträchtigen.

Die Erfindung hat sich daher die Aufgabe gestellt, eine verbesserte Tragevorrichtung und ein entsprechend angepasstes elektronisches Gerät bereitzustellen, sodass die erörterten Probleme vermieden sind.

### Zusammenfassung der Erfindung

Diese Aufgabe wird durch eine Tragevorrichtung gelöst. Der Gegenstand der Erfindung ist daher ein Tragevorrichtung, bevorzugt realisiert als Regalschiene, für die mechanische Befestigung eines elektronischen Geräts, besonders bevorzugt für die Befestigung einer elektronischen Anzeigeeinheit, wobei die Tragevorrichtung aufweist eine erste Begrenzungswand, insbesondere eine Referenz.- bzw. Positionierung-Ebene definierende Referenzwand, an der oder benachbart zu der das elektronische Gerät, insbesondere mit seiner Rückwand, an der Tragevorrichtung positionierbar ist, und eine in einem Winkel zu der ersten Begrenzungswand orientierte zweite Begrenzungswand, wobei die erste Begrenzungswand und die zweite Begrenzungswand, insbesondere nur zweiseitig, einen Aufnahmebereich für die Aufnahme des elektronischen Geräts begrenzen, und einen Leitungsträger, der Leitungsbahnen zur elektronischen Versorgung des Geräts trägt, dadurch gekennzeichnet, dass der Leitungsträger in einem Abstand von der ersten Begrenzungswand ausgehend von der zweiten Begrenzungswand, insbesondere parallel zu der ersten Begrenzungswand, in den Aufnahmebereich hineinragt.

Weiterhin wird diese Aufgabe durch eine Versorgungseinrichtung gelöst. Der Gegenstand der Erfindung ist daher eine Versorgungseinrichtung für eine Tragevorrichtung, insbesondere realisiert als Regalschiene, zur elektrischen Versorgung eines durch die Tragevorrichtung tragbaren elektronischen Geräts, besonders bevorzugt einer elektronischen Anzeigeeinheit, wobei die Versorgungseinrichtung derart ausgebildet ist, dass sie mit einem Seiten- bzw. Endabschnitt der Tragevorrichtung, welcher Seiten- bzw. Endabschnitt zur Aufnahme der Versorgungseinrichtung ausgebildet bzw. vorgesehen ist, koppelbar ist, wobei die Versorgungseinrichtung aufweist: eine Versorgungselektronik und mit der Versorgungselektronik verbundene Kontakte zum Herstellen einer elektrisch leitfähigen Verbindung mit auf einem Leitungsträger der Tragevorrichtung angeordneten Leitungsbahnen, dadurch gekennzeichnet, dass die Kontakte durch eine erste Gruppe metallischer Kontaktbänder realisiert sind, wobei jedes Kontaktband einen ersten Abschnitt, bevorzugt ersten Endabschnitt, aufweist, welcher erste Abschnitt mit der Versorgungselektronik verbunden ist, und einen zweiten Abschnitt, bevorzugt zweiten Endabschnitt, aufweist, welcher zweite Abschnitt zur Kontaktierung der Leitungsbahnen des Leitungsträgers bestimmt ist, und wobei jedes Kontaktband gekrümmt oder gewinkelt, bevorzugt zumindest L-Förmig, besonders bevorzugt C- bzw. U-Förmig, ausgebildet ist.

Weiterhin wird diese Aufgabe durch ein elektronisches Gerät gelöst. Der Gegenstand der Erfindung ist daher ein elektronisches Gerät, insbesondere elektronische Anzeigeeinheit, das ein Gehäuse mit einer Rückwand, einer Frontwand, insbesondere mit einem Bildschirm, und einer zwischen der Rückwand und der Frontwand verlaufenden Seitenwand aufweist, wobei die Seitenwand eine im Wesentlichen parallel zur Rückwand verlaufende Leitungsträger-Nut aufweist, die zur Aufnahme eines Leitungsträgers einer Tragevorrichtung bestimmt ist, wobei der Leitungsträger Leitungsbahnen zur elektronischen Versorgung des elektronischen Geräts, insbesondere der Anzeigeeinheit, aufweist.

Weiterhin wird diese Aufgabe durch ein System gelöst. Der Gegenstand der Erfindung ist daher ein System, das eine erfindungsgemäße Tragevorrichtung, eine damit gekoppelte erfindungsgemäße Versorgungseinrichtung und zumindest ein durch die Tragevorrichtung getragenes erfindungsgemäßes elektronisches Gerät aufweist.

Mit den erfindungsgemäßen Maßnahmen geht der Vorteil einher, dass das Einsetzen eines elektronischen Geräts wesentlich erleichtert wird. Durch den mit den erfindungsgemäßen Maßnahmen einhergehenden Wegfall der Befestigungskante der unteren Seitenwand, wie sie die bekannte Regalschiene aufweist, kann das elektronische Gerät einfach, ohne Kippbewegungen in die Tragevorrichtung geschoben werden. Dies bedeutet, dass das elektronische Gerät entlang der ersten Begrenzungswand, die hierbei auch als Referenzwand fungieren kann, einschiebbar hin zur zweiten Begrenzungswand bewegbar ist, insbesondere so, dass das einzuschiebende elektronische Gerät nicht von der ersten Begrenzungswand abgehoben werden muss.

Dies gilt in äquivalenter Weise für die Entnahme des elektronischen Geräts.

Durch den Wegfall der nachteiligen Ausbildung des Stands der Technik, also durch den Wegfall der (bei horizontalem Einbau der Regalschiene unteren) Befestigungskante und damit auch der Rinne geht weiterhin der Vorteil einher, dass sich an dieser Stelle kein Schmutz in Form von festen oder flüssigen Stoffen mehr anlagern kann. Die darauf zurückzuführenden optischen Beeinträchtigungen wie auch funktionalen Störungen sind somit de facto ausgeschlossen.

Auch ist durch die Verlagerung der Leitungsbahnen des Leitungsträgers in einen Bereich innerhalb des Aufnahmebereichs, der ja von den beiden Begrenzungswänden eingefasst bzw. begrenzt ist, weitgehend sichergestellt, dass die Leitungsbahnen dort kaum bis gar nicht verschmutzen können. Gleiches gilt sinngemäß für die zur Aufnahme des Leitungsträgers vorgesehene Leitungsträger-Nut des elektronischen Geräts, wo sich die Kontakte des elektronischen Geräts befinden. Diese Leitungsträgernut ist nämlich bei eingesetztem Gerät in die Tragevorrichtung durch die zweite Begrenzungswand der Tragevorrichtung abgedeckt, also geschützt.

Es lässt sich also durch die erfindungsgemäßen Maßnahmen die Wartungsintensität der Tragevorrichtung, insbesondere realisiert als Regalschiene, bzw. des gesamten Systems erheblich reduzieren. Reinigung wird einfacher und seltener notwendig, weil die in Bezug auf Schmutz kritische Stelle in der erfindungsgemäßen Ausbildung beseitigt ist oder nun so angeordnet und ausgebildet ist, dass das Risiko einer Verunreinigung möglichst minimiert ist.

Die Orientierung des Leitungsträgers in Bezug auf die erste Begrenzungswand ist im bevorzugten Fall parallel zu dieser. Allerdings kann auch eine andere Orientierung vorgesehen sein. So kann der Leitungsträger z.B. auch so orientiert sein, dass sich ausgehend von der zweiten Begrenzungswand betrachtet sein Abstand von der ersten Begrenzungswand kontinuierlich erhöht. Der Leitungsträger ist dann in dem Aufnahmebereich leicht schräg nach vorne in Richtung der offenen (also nicht durch die Begrenzungswände begrenzten) Seiten des Aufnahmebereichs orientiert. In diesem Fall kann auch die Orientierung der Leitungsträger-Nut in Bezug auf die Rückwand des elektronischen Geräts entsprechend angepasst sein, sodass sich das elektronische Gerät entlang des Leitungsträgers gleitend hin zu der ersten Begrenzungswand in den Aufnahmebereich einsetzen lässt.

Auch muss bei der ersten Begrenzungswand die Rückseite dieser ersten Begrenzungswand nicht zwingend parallel zur Vorderseite der ersten Begrenzungswand verlaufen. Vielmehr kann auch vorgesehen sein, dass die Vorderseite und die Rückseite der ersten Begrenzungswand in Betrachtungsrichtung hin zu der zweiten Begrenzungswand keilförmig aufeinander zulaufend orientiert sind. Der Querschnitt der ersten Begrenzungswand kann somit auch im Wesentlichen keilförmig realisiert sein. Es kann also zwischen der Rückseite der Begrenzungswand und einer im Bezug dazu geneigten Vorderseite der Begrenzungswand (z.B. als Referenzseite bezeichnet) unterschieden werden. Auch in diesem Fall kann die Orientierung des Leitungsträgers wie bereits erwähnt entweder parallel zu der Vorderseite der Begrenzungswand oder eben in einem Winkel weg geneigte von dieser orientiert sein, wobei im letzteren Fall wieder die Orientierung der leitungsträger-Nut entsprechend anzupassen wäre, wie vorangehend erörtert.

Gleichfalls wäre es auch möglich, nicht die Orientierung der Leitungsträger-Nut anzupassen, sondern diese im Wesentlichen parallel zur Vorderseite des elektronischen Geräts zu belassen oder auch zentral zwischen der Vorderseite und er Rückseite des elektronischen Geräts verlaufen zu lassen und die Orientierung der Rückwand des elektronischen Gerätes anzupassen, um einen im Wesentlichen formschlüssigen Sitz des in die Tragevorrichtung eingesetzten elektronischen Gerät zu erzielen.

Dadurch, dass das elektronische Gerät z.B. an einer horizontal verlaufenden Regalschiene von unten her an der Regalschiene zugänglich ist, wird auch die gesamte Handhabung erleichtert.

Weiterhin geht mit den erfindungsgemäßen Maßnahmen der Vorteil einher, dass die Tragevorrichtung kompakter wird und somit das Sichtfeld auf dahinter befindliche Gegenstände, insbesondere Waren, vergrößert ist. So kann beispielsweise ein Kunde bei einer erfindungsgemäßen Tragevorrichtung beispielhaft ausgeführt als Regalschiene gut die Produkte im Regal unter der Regalschiene begutachten, ohne durch nach unten hin ausladende Strukturelemente der Regalschiene daran gehindert zu werden.

Generell ermöglichen diese erfindungsgemäßen Maßnahmen ein freieres und leichteres Erscheinungsbild des Systems, speziell der Tragevorrichtung und der daran befestigten elektronischen Geräte, insbesondere der elektronischen Anzeigeeinheiten, und ermöglichen damit eine bessere Präsentation der Waren.

Die erfindungsgemäßen Maßnahmen und der damit einhergehende Wegfall der unteren Befestigungskante ermöglicht weiterhin die Verwendung von elektronischen Geräten, die parallel zur ersten Begrenzungswand (Referenzwand) eine Ausdehnung aufweisen können, die jene der ersten Begrenzungswand geringfügig überschreitet, ggf. auch massiv überschreitet. Die Regalschiene als solches kann somit im Vergleich zu den Anzeigeeinheiten schlanker ausfallen, was die Aufmerksamkeit automatisch auf die Anzeigeeinheiten fallen lässt, ohne dass die Regalschiene als massives, optisch störendes Element wahrgenommen wird. Der Wegfall der unteren Befestigungskante ermöglicht also die Verwendung von elektronischen Geräten mit nahezu beliebiger Dimension parallel zur ersten Begrenzungswand bzw. zur Referenzwand. Dadurch lässt sich auch nahezu jedes elektronische Gerät für die Verwendung mit einer solchen Tragevorrichtung adaptieren. Insbesondere lassen sich elektronische Anzeigeeinheiten mit sehr spezifischen und unterschiedlichsten Bildschirmabmessungen wie auch großflächige elektronische Interaktionsmedien, wie z.B. Touchscreens, usw. einsetzen. Diese Geräte erscheinen dem Betrachter in der Tragevorrichtung als schwebend gehalten, weil sie an ihrer z.B. unteren Seite die Tragevorrichtung überragen.

Die Tragevorrichtung kann grundsätzlich vielfältig realisiert sein. So kann es sich beispielsweise um einen Tischaufsteller handeln, der auf einem Ladentisch aufgestellt oder dort fixiert werden kann. Ebenso ist es möglich, die Tragestruktur als Kleidungsanhänger auszubilden, der an einer Kleidung hängend dort fixiert sein kann. Aus Gründen der kompakten Beschreibung der Erfindung wird jedoch nachfolgend ausschließlich auf eine Regalschiene als bevorzugte Ausbildungsform der Tragevorrichtung Bezug genommen.

Auch kann die Orientierung der Tragevorrichtung und somit auch die Orientierung der an ihr befestigten Geräte beliebig sein.

Die elektrisch leitende Verbindung zwischen Versorgungseinrichtung und Tragevorrichtung kann bedingt lösbar oder unlösbar, also insbesondere stoffschlüssig z.B. mittels Lötverbindungen realisiert sein.

In vielen Fällen ist es vorteilhaft, wenn die elektrisch leitende Verbindung einfach wieder trennbar ist. Eine solche Verbindung lässt sich unter anderem mittels lösbarer Verbindungen, wie Steckverbindungen oder Schraubverbindungen usw., realisieren.

Bevorzugt ist die elektrisch leitende Verbindung als lösbare Verbindungen, die ein Federelement aufweist, realisiert. So ein Federelement stellt sicher, dass auch bei Positionsänderungen der zu verbindenden Bauteile in einem gewissen Bereich der elektrische Kontakt mit einer Mindestkraft sichergestellt bleibt. Eine solche Positionsänderung kann beispielsweise durch Fertigungstoleranzen, thermische Ausdehnung, verschleißbedingte Verformung, ungenaues zusammensetzen der Komponenten oder mechanische Belastung der Systemkomponenten hervorgerufen werden bzw. sein.

Bevorzugt weist die Versorgungseinrichtung die erste Gruppe metallischer Kontaktbänder, also elektrisch leitende Metall-Kontaktbänder auf. Diese Kontaktbänder sind zur Bereitstellung der elektrisch leitenden Verbindung mit der Tragevorrichtung bzw. mit den Leitungsbahnen der Tragevorrichtung ausgebildet.

Diese Kontaktbänder können zur Realisierung eines unlösbaren, wie zum Beispiel stoffschlüssigen, oder lösbaren Kontakts ausgebildet sein.

Bei einer Ausführungsform für einen Kontakt mittels Steckverbindung sind die Kontaktbänder so ausgeführt, dass sie, wenn die Versorgungseinrichtung in die Tragevorrichtung eingeschoben wird, die Kontaktbänder an die Leitungsbahnen herangeführt werden. Die Umgebung der Leitungsbahnen ist hierfür so ausgebildet, dass ein Ausweichen der Kontaktbänder weg von den Leitungsbahnen verhindert wird. Bedingt durch lokale Verformung im elastischen Bereich kommt es zur sicheren Kontaktierung.

Zur Realisierung eines unlösbaren, insbesondere stoffschlüssigen Kontakts können die Kontaktbänder so ausgeführt sein, dass sie im eingeschobenen Zustand der Tragevorrichtung mit den Leitungsbahnen in Kontakt stehen, woraufhin sie beispielsweise verlötet werden können.

Bevorzugt kommt jedoch eine lösbare federbasierte Verbindung zum Einsatz, also eine Verbindung, die ein Federelement aufweist. In diesem Fall sind die Kontaktbänder so ausgeführt, dass sie, wenn die Versorgungseinrichtung in die Tragevorrichtung eingeschoben wird, durch eine Federkraft gegen die Leitungsbahnen gedrückt werden. Im Unterschied zu einer Steckverbindung entsteht die Kraft, die die Kontaktierung sicherstellt, also nicht bzw. nicht nur lokal durch Verformung an der Kontaktstelle, sondern auch bzw. insbesondere durch Verformung, beispielsweise Biegung, an einer Stelle, die nicht die Kontaktstelle ist, oder entlang des Kontaktbands.

Besonders bevorzugt bilden die Kontaktbänder selbst die Federelemente. Sie sind also als Versorgung-Feder-Kontaktelemente ausgeführt.

Wie erwähnt weisen die Kontaktbänder einen ersten Abschnitt, bevorzugt einen ersten Endabschnitt, auf, der mit der Versorgungselektronik verbunden ist. Weiterhin weisen die Kontaktbänder einen zweiten Abschnitt, bevorzugt zweiten Endabschnitt, auf, der zum Bereitstellen der elektrisch leitenden Verbindung bzw. des Kontakts ausgebildet ist.

Die Kontaktbänder können in verschiedenen Formen ausgebildet sein, bzw. kann die Anordnung des ersten und zweiten Abschnitts unterschiedlich ausgeführt sein.

So kann in einer einfachen Ausbildungsform das Kontaktband stabförmig ausgeführt sein, sodass der erste und zweite Abschnitt im Wesentlichen auf einer Ebene entlang der Staboberfläche liegen.

Es ist auch möglich, dass die beide Abschnitte etwas versetzt, aber im Wesentlichen parallel zueinander, also mit einer Stufe oder mehreren Stufen bzw. z-förmig ausgebildet sind.

Es ist auch möglich, dass beide Abschnitte mit einem Winkel relativ zueinander angeordnet sind, sodass eine L-Form bzw. eine V-Form entsteht.

Es ist auch möglich, dass beide Abschnitte im Wesentlichen parallel zueinander, jedoch mit mehreren gewinkelten Abschnitten dazwischen angeordnet sind, sodass eine C- Form bzw. U-Form oder eine W-Form entsteht.

Neben den genannten Ausbildungsformen sind auch weitere mehrstufige Ausbildungen der Abschnitte möglich, sodass beispielsweise mäanderförmige Kontaktbänder entstehen.

Die gewinkelten und mehrstufigen Ausbildungsformen haben den Vorteil, dass ein größerer Federweg bei gleichzeitig geringerer Materialbelastung möglich ist, weshalb diese die bevorzugte Ausbildungsformen darstellen. Dies lässt sich auch mit einer gekrümmten Form der metallischen Kontaktbänder realisieren.

Weiterhin erlaubt die bandförmige Ausbildung der Kontaktbänder diese so zu führen bzw. zu formen, dass Niveauunterschiede zwischen der Elektronik, mit der sie verbunden sind, und der Ebene der Leitungsbahnen, welche zu kontaktieren sind, problemlos überwunden werden. Auch geht damit die Wirkung einher, dass die Kontaktierung mit einer vordefinierten Minimalkraft (aber auch Maximalkraft, also innerhalb eines Bereichs der auftretenden Kraft) erfolgen kann, die sich durch die Formgebung und die elastischen Eigenschaften des Materials der Kontaktbänder einstellen bzw. definieren lässt.

Bevorzugt kommen korrosionsbeständige Stahlbänder zum Einsatz.

Es wird also trotz Beweglichkeit der Kontaktflächen bzw. -zonen auf komplizierte, insbesondere relativ zueinander bewegliche, mechanische Einzel-Komponenten verzichtet.

Weitere, besonders vorteilhafte Ausgestaltungen und Weiterbildungen der Erfindung ergeben sich aus den abhängigen Ansprüchen sowie der nachfolgenden Beschreibung.

Als nicht abschließende Aufzählung von Beispielen für elektronische Geräte seien Sensoreinheiten bzw. Sensoren wie Bewegungssensoren, Temperatursensoren, Lichtsensoren und Kameras, Eingabegeräte wie Knöpfe, Berührungssensoren, Touch-Screens, Ausgabegeräte wie Beleuchtungen, Lautsprecher, Drucker, z.B. Thermodrucker, oder elektronische Anzeigeeinheiten, wie beispielsweise ausgeführt mittels Liquid-Crystal Display (LCD) Bildschirmen, Organic Light Emitting Diodes (OLED) Bildschirmen usw. oder E-Paper-Displays bzw. elektrophoretische Displays, genannt.

Die Versorgungseinrichtung versorgt die elektronischen Geräte sowohl mit der nötigen Versorgungsspannung zum Betreiben selbiger als auch kommunikationstechnisch. Sie übernimmt also neben der Leistungsversorgung (Versorgungsspannung und Strom) auch die daten- bzw. signaltechnische Versorgung zwecks Übertragung von Information wie auch Ansteuerung des bzw. der elektronischen Geräte. Zwecks Leistungsversorgung kann die Versorgungseinrichtung mit einem Netzgerät, mit einer (wieder aufladbaren) Batteriekonfiguration oder mittels "Power over WiFi" versorgt werden. Im Fall einer (auch aufladbaren) Batterie oder auch eines Akkumulators kann dieser Energiespeicher bevorzugt mit Hilfe von Magneten an der Tragevorrichtung oder einem benachbarten Bauteil in unmittelbarer Nähe zu der Versorgungseinrichtung befestigt sein, um einen raschen und unkomplizierte Austausch zu ermöglichen. Auch kann die Tragevorrichtung mit einem Photovoltaikmodul ausgerüstet sein, das zum Energie-Sammeln zwecks Speicherung in einer aufladbaren Batterie genutzt wird.

Die Versorgungseinrichtung bzw. die Versorgungselektronik der Versorgungseinrichtung kann weiterhin dazu ausgebildet sein, Daten zu verarbeiten oder aufzubereiten, also beispielsweise Daten von einem Server über einen Accesspoint zu empfangen und in von dem elektronischen Gerät lesbare bzw. verarbeitbare Signale bzw. Daten umzuwandeln oder einfach nur als Rohdaten an die betroffenen (adressierten) Geräte weiterzuleiten. Auch können Daten von den Geräten empfangen werden und über den Accesspoint an den Server abgegeben werden Diese Übertragungen zwischen dem Accesspoint und der Versorgungseinrichtung können leitungsgebunden oder funkbasiert erfolgen.

Die Versorgungseinrichtung kann unabhängig von der Tragevorrichtung platziert sein oder hinter der Tragevorrichtung oder an einer Seite der Tragevorrichtung an dieser befestigt sein und mit den Leitungsbahnen des Leitungsträger der Tragevorrichtung elektrisch leitend verbunden sein.

In diesem Kontext hat es sich als besonders vorteilhaft erwiesen, wenn die Tragevorrichtung einen Seitenabschnitt aufweist, der zur Aufnahme der Versorgungseinrichtung zwecks elektrischer Versorgung von durch die Tragevorrichtung tragbaren elektronischen Geräten ausgebildet bzw. vorgesehen ist.

Bevorzugt ist die Versorgungseinrichtung entsprechend ausgebildet, um in den Seitenabschnitt der Tragevorrichtung aufgenommen zu werden.

Dadurch wird ein sehr kompaktes System geschaffen, wobei gleichzeitig die Versorgungseinrichtung gegenüber Umwelteinflüssen, wie z.B. Feuchtigkeit oder mechanische Belastung, in der Struktur der Tragevorrichtung geschützt aufgenommen ist.

Es sind so weder lose Verkabelungen zwischen der Versorgungseinrichtung und der Tragevorrichtung einsehbar noch manipulierbar.

Eine volle Integration einer separaten Versorgungseinrichtung in die Schiene ist bevorzugt, wobei in diesem Fall z.B. auch ein Gehäuse der Versorgungseinrichtung an die Form der Tragevorrichtung angepasst ist, sodass beide zusammen den Eindruck erwecken, als wären sie aus einem Guss.

Weiterhin hat es sich als vorteilhaft erwiesen, wenn jedes Kontaktband an seinem zweiten Abschnitt eine Bogenform aufweist, die für den direkten Kontakt mit einer der Leitungsbahnen vorgesehen ist.

Diese Bogenform verhindert, dass der zweite Abschnitt der Kontaktbänder beim Einsetzen der Versorgungseinrichtung in die Tragevorrichtung verkeilt bzw. sich verfängt. So ein Verkeilen bzw. Verfangen könnte bei unvorsichtigem bzw. schnellem Einsetzen zur Beschädigung der Komponenten, beispielsweise zur Verformung der Kontaktbänder oder auch der Leitungsbahnen führen. Die Bogenform erlaubt daher ein schnelleres und wirtschaftliches Zusammensetzen und Warten des Systems ohne die genannten Risiken.

Mit dieser Form geht auch ein verbesserter Kontakt einher, weil so durch den Krümmungsradius der Bogenform eine definierte Kontaktfläche bzw. -zone entlang des Metallbands entsteht.

Zur Optimierung des Kontakts zwischen der Leitungsbahn und dem Kontaktband kann die Bogenform des zweiten Abschnitts einen an die Form der Leitungsbahn angepasst Kontaktierungsbereich aufweisen. So kann die Oberfläche der Bogenform bei kreisrundem Leitungsbahnquerschnitten beispielsweise eine entsprechende auf die Leitungsbahn angepasste halbkreisrunde Kerbe bzw. Nut aufweisen, sodass die Kontaktfläche bzw. -zone entlang der Krümmung der Leitungsbahn vergrößert wird.

Gemäß einem weiteren Aspekt weist die Versorgungseinrichtung ein Gehäuseteil auf, das zumindest einseitig offen ist, sodass der Leitungsträger an der offenen Gehäuseseite einführbar ist, wobei das Gehäuseteil derart geformt ist, dass die zweiten Abschnitte der Kontaktbänder und der damit kontaktierbare Teil der Leitungsbahnen, also der betroffene Teil des Leitungsträgers umfasst sind.

Diese Ausbildungsform bietet den eingefassten Kontaktbändern und Leitungsbahnen Schutz. Schutz bietet es insbesondere vor Berührung, Feuchtigkeit, mechanischer Belastung, thermischer Belastung und unerwünschter Sicht auf die Komponenten, also Sichtschutz.

Das Gehäuseteil stellt zudem eine definierte Positionierung der Kontaktbänder relativ zu den Leitungsbahnen sicher. Zu diesem Zweck weist das Gehäuse Abschnitte oder Flächen auf, an denen das Gehäuseteil mit der Tragevorrichtung zusammenwirkt und dort entsprechend positioniert bzw. gehalten wird.

Das Gehäuseteil gibt gleichzeitig der Versorgungseinrichtung Stabilität und stellt die Struktur bereit, alle Komponenten der Versorgungseinrichtung an ihrer Sollposition zu halten.

Das Gehäuseteil kann so ausgebildet sein, dass es zusätzlich einen Teil des Leitungsträgers abdeckt bzw. aufnimmt. Diese Maßnahme erschwert im zusammengebauten Zustand zusätzlich unerlaubte Manipulation an den elektronischen Komponenten des Systems. Steht das Gehäuse auch mit dem Leitungsträger in Kontakt, sichert diese Maßnahme die mechanische Stabilität an jener Stelle, wo die metallischen Kontaktbänder mit ihrer durch die Federwirkung verursachten Kraft auf die Leitungsbahnen und in Folge auf den Leitungsträger drücken.

Der Leitungsträger der Tragevorrichtung kann einteilig oder mehrteilig ausgeführt sein. In beiden Fällen ist es möglich, dass die Leitungsbahnen in einer oder in mehreren Ebenen liegen, wobei die Kontaktbänder der Versorgungseinrichtung entsprechend ausgestaltet bzw. angeordnet sein müssen, um die Leitungsbahnen zu kontaktieren.

Es hat sich jedoch als besonders vorteilhaft erwiesen, wenn der Leitungsträger der Tragevorrichtung als Leitungsträgerplatte ausgebildet ist.

Dies stellt eine sehr platzsparende, schlanke und gleichzeitig stabile Ausbildungsform dar und lässt ausreichend Platz für die Leitungsbahnen. An der Leitungsträgerplatte können die Leitungsbahnen an einer Seite der Platte oder an unterschiedlichen Seiten positioniert sein. Die Leitungsträgerplatte bietet vor allem den Vorteil, dass die Leitungsbahnen mit ausreichendem Abstand zueinander entlang der Leitungsträgerplatte z.B. in einer Ebene verlaufen können.

Die Verwendung einer Leitungsträgerplatte bietet bei bestimmungsgemäßer Verwendung des Systems dem elektronischen Gerät definierte Kontaktpunkte bzw. -zonen, wo der Leitungsträger bzw. die Leitungsträgerplatte mit dem elektronischen Gerät in Kontakt steht. Insbesondere vollständig eingeführt in die Leitungsträger-Nut des Geräts ist die Position des Geräts genau definiert, was sich insbesondere in Form einer zuverlässigen elektronischen Kontaktierung äußert.

Gemäß einem weiteren Aspekt weist die Leitungsträgerplatte eine erste Abmessung auf, die entlang der Längserstreckung der Tragevorrichtung gemessen wird, und eine zweite Abmessung auf, die in der Ebenen der Leitungsträgerplatte normal auf die erste Abmessung der Leitungsträgerplatte gemessen wird, wobei die zweite Abmessung der Leitungsträgerplatte 20% bis 40% der dazu korrespondierenden Abmessung der ersten Begrenzungswand entspricht.

Damit wird erreicht, dass die Leitungsträger-Platte ausreichend stabil und steif ausgeführt ist, während zugleich auch ein ausreichender Abstand zwischen den Leitungsbahnen sichergestellt ist.

Weiterhin ermöglichen diese Abmessungsverhältnisse eine einfache Entnahme der elektronischen Geräte aus der Tragevorrichtung und ein einfaches Einsetzten bzw. Positionieren der elektronischen Geräte in die Tragevorrichtung, weil sich bei dem Einführen in die Tragevorrichtung bzw. beim Herausziehen aus der Tragevorrichtung durch die Abmessung der Leitungsträgerplatte eine räumliche Führung für die Bewegung des Geräts etabliert.

Weil bei diesen Abmessungen unter Verwendung der üblichen Materialien und Materialstärken eine ausreichende Stabilität und Steifigkeit gegeben ist, können Fehlstellungen der Leitungsträgerplatte in Bezug zur ersten Begrenzungswand zuverlässig vermieden werden, wodurch auch ein klemmfreies Verschieben bzw. Versetzten der elektronischen Geräte entlang der Tragevorrichtung gewährleistet ist.

Bevorzugt erstreckt sich die erste Abmessung über die gesamte Länge der Tragevorrichtung, damit auch die Geräte entlang der gesamten Länge versorgbar sind.

Der Leitungsträger kann mehrere Leitungsbahnen für die signaltechnische Versorgung und mehrere, insbesondere zwei Leitungsbahnen für die Leistungsversorgung aufweisen. So kann z.B. ein Paar der Leitungsbahnen zur elektrischen Leistungsversorgung dienen und weitere z.B. zehn Leitungsbannen einen Datenbus zur bidirektionalen parallelen Informationsübertragung realisieren.

Bevorzugt weist der Leitungsträger jedoch genau drei Stück der Leitungsbahnen auf, die bevorzugt an einer einzigen Seitenfläche des Leitungsträgers ausgebildet sind und/oder parallel zueinander entlang der Längserstreckung der Tragevorrichtung verlaufen.

Diese Ausbildungsform erlaubt sowohl eine signaltechnische Versorgung als auch eine Leistungsversorgung mit möglichst wenigen Komponenten, insbesondere Kontakt-Komponenten, wie konkret die Kontaktbänder. Somit ist eine kompakte und platzsparende Realisierung ermöglicht.

Die wenigen Komponenten machen diese Realisierung auch weniger Anfällig für Fehlfunktionen, was in Folge die Betriebssicherheit erhöht und folglich den Gesamtwartungsaufwand reduziert. Auch geht damit eine kostengünstige Herstellung einher.

Die Ausführung des Leitungsträgers mit genau drei Stück der Leitungsbahnen, lässt sich realisieren, indem sowohl die Signal- bzw. Datenversorgungsleitung, die eine der Leitungsbahnen darstellt, als auch die Leistungsversorgungsleitung, die eine weitere Leitungsbahn darstellt, dasselbe Bezugspotential nutzen, wobei die dritte Leitungsbahn, hier auch Bezugspotenzial-Leitung genannt, dieses Bezugspotential aufweist.

Besonders bevorzugt sind die Leitungsbahnen in Bezug auf die Einschieberichtung des elektronischen Geräts so geordnet, dass als erstes die Massenleitung, anschließend die Signal- bzw. Datenversorgungsleitung und abschließend die Leistungsversorgungsleitung angeordnet ist. Somit ist der Stromkreis zwischen Leistungsversorgungsleitung und Massenleitung erst im vollständig eingeschobenen Zustand gegeben, was Kurzschlüsse und Beschädigungen der elektronischen Komponenten vermeidet.

Die Leitungsbahnen der Tragevorrichtung können unterschiedliche Formen bzw. Querschnitte haben.

Gemäß einer Ausbildungsform können diese Leitungsbahnen flach sein bzw. einen viereckigen Querschnitt aufweisen. Diese Ausbildungsform bietet den Vorteil, dass bei federbasierten Verbindungen ein großer Leitungsquerschnitt an den Kontaktstellen sichergestellt ist. Flache Leitungsbahnen lassen sich als Bahnen auf der Trägerplatte z.B. ähnlich wie bei Printplatten, leicht realisieren.

Gemäß einer bevorzugten Ausbildungsform sind die Leitungsbahnen jedoch als Drähte ausgeführt, die teilweise über die Außenfläche des Leitungsträgers hervorragen.

Neben den fertigungstechnischen Vorteilen bietet diese Ausbildungsform Vorteile in Bezug auf die elektrische Kontaktierung mit den elektronischen Geräten.

Dies kommt insbesondere dann zum Tragen, wenn das elektronische Gerät, insbesondere die elektronische Anzeigeeinheit, gemäß einer bevorzugten Ausbildungsform Kontakte zur Herstellung einer elektrisch leitfähigen Verbindung mit den Leitungsbahnen des Leitungsträgers aufweist, wobei jener Gehäuseteil, der die Leitungsträger-Nut bildet, erste Gehäuseöffnungen aufweist, durch die hindurch die Kontakte aus dem Gehäuse herausragen.

Die Leitungsträger-Nut erlaubt eine klar definierte Positionierung des elektronischen Geräts und dessen Kontakte in Bezug auf die Leitungsbahnen, sodass die Kontakte zuverlässig und ohne weitere Justierung automatisch eine elektrisch leitende Verbindung mit den Leitungsbahnen eingehen, sobald das Gerät an der Tragevorrichtung befestigt ist, also der Leitungsträger in seiner Soll-Position in der Leitungsträger-Nut positioniert ist.

Drähte als Leitungsbahnen weisen einen im Wesentlichen runden Querschnitt auf, der erhaben über die Fläche des Leitungsträgers herausragt. Dieser Querschnitt erlaubt, anders als ein flacher Querschnitt, der im Wesentlichen plan mit der Fläche des Leitungsträgers abschließt, eine taktile Rückmeldung beim Einsetzen des elektronischen Geräts, sobald einer der Kontakte des elektronischen Geräts einen der Drähte berührt. So kann der Benutzer leicht feststellen, ob der jeweilige Kontakt des Geräts bereits den Leitungsträger erreicht bzw. passiert hat.

Drähte als Leitungsbahnen überzeugen weiterhin auf Grund ihrer Robustheit gegenüber beispielsweise flachen Leitungsbahnen.

Bevorzugt sind die Drähte mit mindestens 50 % ihres Querschnitts im Leitungsträger verortet. Bei dieser Ausbildungsform ist ein sicherer Halt im Leitungsträger gegeben, weil der Leitungsträger den jeweiligen Draht zumindest mit etwas mehr als 180° umfangseitig umfasst. Es ist also ein ungewolltes Herausfallen der Leitungsbahn aus dem Leitungsträges zuverlässig verhindert

Die Leitungsbahnen können am Leitungsträger so angeordnet sein, dass sie an jener der ersten Begrenzungswand bzw. der Referenzwand abgewandten Seite des Leitungsträgers angeordnet sind.

Bevorzugt ist die Tragevorrichtung jedoch so ausgebildet, dass die Leitungsbahnen an jener der ersten Begrenzungswand bzw. der Referenzwand zugewandten Seite des Leitungsträgers angeordnet sind.

Das elektronische Gerät ist folglich bevorzugt so ausgebildet, dass die ersten Gehäuseöffnungen an jener Seite der Leitungsträger-Nut realisiert sind, die der Rückwand am nächsten ist.

Mit den Maßnahmen dieser bevorzugten Ausbildungsformen geht der Vorteil einher, dass die Leitungsbahnen nur schwer bis gar nicht einsehbar sind und eine versehentliche oder beabsichtigte Berührung, insbesondere mit einem leitenden Gegenstand, nahezu ausgeschlossen ist. Infolgedessen wird auch die Gefahr eines Kurzschlusses oder einer Übertragungsstörung reduziert oder vollständig ausgeschlossen. Diese im Wesentlichen vor den Blicken eines Betrachters der Tragevorrichtung (z.B. einer Regalschiene) versteckte Anordnung der Leiterbahnen bietet überdies einen weitreichenden Schutz vor Verschmutzung, sodass ein diesbezüglicher Wartungsaufwand zu vernachlässigen ist.

Gemäß einem weiteren Aspekt ist das elektronische Gerät, so ausgebildet, dass jeweils eine der Gehäuseöffnungen zur Position von genau einer der Leitungsbahnen korrespondiert, wenn der Leitungsträger bestimmungsgemäß in die Leitungsträger-Nut eingesetzt ist.

Dies stellt sicher, dass beim Zusammenfügen der Geräte mit der Tragevorrichtung immer genau definierte Kontaktierungszonen vorliegen, die in der End- bzw. Sollposition zu einer präzisen Kontaktierung der Leitungsbahnen führen. Somit ergeben sich beim vollendeten Einsetzen des elektronischen Geräts in die Tragevorrichtung unweigerlich korrekte elektrische Verbindungen, ohne dass ein Nachjustieren oder Korrigieren der Relativposition der beiden Gegenstände nötig wäre.

Gemäß eines weiteren Aspekts sind die Kontakte der elektronischen Geräte als eine zweite Gruppe metallischer Kontaktbänder realisiert, wobei jedes Kontaktband einen ersten Abschnitt, bevorzugt ersten Endabschnitt, aufweist, welcher erster Abschnitt mit einer Gerät-Elektronik verbunden ist, und einen zweiten Abschnitt, bevorzugt zweiten Endabschnitt, aufweist, welcher zweite Abschnitt zur Kontaktierung der Leitungsbahnen des Leitungsträgers bestimmt ist, wobei die zweite Gruppe metallischer Kontaktbänder als Federelemente ausgeführt sind, wobei bevorzugt jedes Kontaktband gekrümmt oder gewinkelt, insbesondere stufenförmig, ausgebildet ist.

Dies erlaubt eine druckbeaufschlagte Kontaktierung. Somit kommen die im Kontext der ersten Gruppe metallischer Kontaktbänder bei Ausführung als federbasierte elektrisch leitende Verbindung genannten Vorteile auch hier zu tragen. So können beispielsweise auch hier Winkelfehler und Versätze der Kontaktflächen ausgeglichen werden.

Die aus dem Stand der Technik bekannten Kontakte, bei denen eine Schraubenfeder den stiftförmigen Kontakt in einer Linearbewegung auf den Gegenkontakt drückt, haben sich nicht nur wegen ihrer vielen Komponenten, sondern auch wegen ihrer Störanfälligkeit, insbesondere bei Verschmutzung, als nachteilig herausgestellt.

Durch die Ausführung der zweiten Gruppe metallischer Kontaktbänder als (im wesentlich einteilige) Federelemente sind Nachteile von teleskopbasierten Feder-Kontakten überwunden. Schmutzpartikel, wie beispielsweise Körner oder Staub oder auch klebrige Flüssigkeiten, die bei diesen bekannten Systemen ausreichen können, Fehlfunktionen zu verursachen, haben auf die erfindungsgemäße Ausbildungsform keinerlei negative Auswirkung.

Sind die Kontaktbänder gemäß einer bevorzugten Ausbildungsform gekrümmt oder gewinkelt, insbesondere stufenförmig ausgebildet, erhöht dies weiterhin den Federweg, was die Gefahr von Verkeilen bzw. Klemmen zufolge von Schmutz oder Abnutzung zusätzlich verringert.

Weiterhin erlaubt die bandförmige Ausbildung der Kontaktbänder diese so zu führen bzw. zu formen, dass Niveauunterschiede zwischen der Elektronik, mit der sie verbunden sind, und der Ebene der Leitungsbahnen, welche zu kontaktieren sind, problemlos überwunden werden. Auch geht damit die Wirkung einher, dass die Kontaktierung mit einer vordefinierten Minimalkraft (aber auch Maximalkraft, also innerhalb eines Bereichs der auftretenden Kraft) erfolgen kann, die sich durch die Formgebung und die elastischen Eigenschaften des Materials der Kontaktbänder einstellen bzw. definieren lässt.

Bevorzugt kommen korrosionsbeständige Stahlbänder zum Einsatz.

Es wird also trotz Beweglichkeit der Kontaktflächen bzw. -zonen auf komplizierte, insbesondere reaktiv zueinander bewegliche, mechanische Einzel-Komponenten verzichtet.

Gemäß einer bevorzugten Ausbildungsform des elektronischen Gerätes, insbesondere der elektronischen Anzeigeeinheit, weist jedes Kontaktband der zweiten Gruppe an seinem zweiten Abschnitt eine erhabene Form auf, die für den direkten Kontakt mit einer der Leitungsbahnen vorgesehen ist, und zumindest die erhabene Form des Kontaktbands an der zugeordneten Gehäuseöffnung aus dem Gehäuse austritt und in den durch die Leitungsträger-Nut begrenzten Raumbereich hineinragt.

Diese erhabene Form erlaubt es, sicher mit jedem Kontaktband jeweils nur eine einzige Leitungsbahn im Wesentlichen punktgenau an der Stelle der erhabenen Form zu kontaktieren, wobei gleichzeitig benachbarte Bereiche des Kotaktbandes im Abstand zu der bzw. den Leitungsbahnen verlaufen, also kontaktfrei zu der bzw. den Leitungsbahnen verlaufen.

Bevorzugt ist die erhabene Form an jener Seite, die im zusammengesetzten Zustand mit einer Leitungsbahn in Kontakt steht, abgerundet.

Diese erhabene Form führt dazu, dass das elektronische Gerät ohne zu verkeilen und mit nahezu keinem Verschleiß in die Tragevorrichtung eingeschoben werden kann. Beim Einschieben gleitet der zweite Abschnitt der Kontaktbänder zunächst entlang der Fläche des Leitungsträgers, bis er eine Leitungsbahn erreicht. Dort angekommen folgt der zweite Abschnitt der Kontaktbänder beim weiteren Einschieben ohne zu verkeilen oder die Leitungsbahn abzukratzen der Querschnittsform der Leitungsbahn.

Diese erhabene Form kann beispielsweise dadurch realisiert sein, dass das Kontaktband an der betreffenden Stelle gebogen ist, sodass es beispielsweise einen Bogen aufweist, der die erhabene Form darstellt. Die erhabene Form kann aber auch beispielsweise durch Anbringen von zusätzlichem Material auf einen sonst linearen zweiten Abschnitt des Kontaktbandes erfolgen. Die gewünschte Form kann aber auch durch andere Umformverfahren erzeugt werden, sodass beispielsweise einem aus Blech bestehenden zweiten Abschnitt durch einen Stempel eine Nasenform aufgezwungen wird.

Die Formgebung der Kontaktbänder kann sowohl für das elektronische Gerät wie auch für die Versorgungseinrichtung auf äquivalente Weise erfolgen.

Der Leitungsträger der Tragevorrichtung kann stoffschlüssig mit der zweiten Begrenzungswand der Tragevorrichtung verbunden sein. So können diese Komponenten beispielsweise miteinander verschweißt oder verklebt sein.

Auch kann der Leitungsträger und die zweite Begrenzungswand zusammen aus einem einzigen Material gefertigt werden. So kann es sich beispielsweise um ein Gussteil handeln.

Weiterhin kann der Leitungsträger und die zweite Begrenzungswand miteinander verschraubt oder vernietet sind.

Der Leitungsträger kann auch mittels Steckverbindung, insbesondere mittels Steckverbindungen mit Widerhaken, mit der Tragevorrichtung verbunden sein.

Als besonders vorteilhaft hat es sich jedoch erwiesen, wenn die zweite Begrenzungswand der Tragevorrichtung einen Aufnahme-Schacht aufweist, der zur Aufnahme, insbesondere zur seitlich einschiebbaren Aufnahme, des Leitungsträgers vorgesehen ist, und der Leitungsträger eine zu der Form des Aufnahmeschachts korrespondierende Form, insbesondere eine T-Form oder eine am Kopf stehende L-Form usw., aufweist und in den Aufnahme-Schacht eingesetzt ist. Dies erlaubt gleichzeitig einen einfachen Zusammenbau des Leitungsträgers mit der Tragestruktur und bietet gleichzeitig gute Stabilität. Der Leitungsträger kann so auch einfach für Wartung oder Reinigung entnommen werden. Der Leitungsträger kann so auch modular als Austauschteil gewechselt werden. So muss beispielsweise bei Beschädigung nicht die gesamte Tragevorrichtung getauscht werden.

Gemäß einem weiteren Aspekt kann die zweite Begrenzungswand der Tragevorrichtung einen Unterstützungssteg aufweisen, der sich im Wesentlichen entlang der Längserstreckung des Leitungsträgers erstreckt und diesen mechanisch unterstützt.

Dieser Unterstützungssteg erlaubt es, den Leitungsträger weniger stabil auszulegen, was einerseits ermöglicht, auf günstigere Materialien zurückzugreifen, und andererseits ermöglicht, ein schmaleres Erscheinungsbild des Leitungsträgers zu realisieren oder auch einfach den Leitungsträger materialsparender zu realisieren.

Mit der mechanischen Aussteifung können auch längere Varianten der Tragevorrichtung realisiert werden. Weiterhin wirkt der Unterstützungssteg Beschädigungen des Leitungsträgers während des Einbaus oder während des Betriebs entgegen. Mit dem Schutz des Leitungsträgers geht auch ein erhöhter Schutz der Leitungsbänder einher, weil der Leitungsträger ggf. weniger stark unter der Einwirkung von Biegemomenten in Mitleidenschaft gezogen bzw. verformt wird.

Der Unterstützungssteg kann beispielsweise aus Kunststoff oder bevorzugt aus Metall gefertigt sein.

Der Unterstützungssteg ist gemäß einer Ausbildungsform dazu ausgebildet neben dem Leitungsträger im Aufnahme-Schacht der zweiten Begrenzungswand aufgenommen zu werden, wobei die zweite Begrenzungswand dementsprechend dazu ausgebildet ist, den Leitungsträger und den Unterstützungssteg gemeinsam aufzunehmen. Hierfür kann der Unterstützungssteg beispielsweise eine T-Form am entsprechenden Ende aufweisen, die in den Aufnahme-Schacht eingeführt wird, und der Leitungsträger kann eine L-Form aufweisen, die an einer Seite der T-Form des Unterstützungsstegs in dem Aufnahme-Schacht befestigt wird.

Bevorzugt ist der Leitungsträger aus Kunststoff gefertigt.

Dies ermöglicht die Ausführung der Leitungsbahnen, insbesondere ausgeführt als Draht, ohne zusätzliche Isolierschicht. Der Leitungsträger selbst ist hier der Isolator. Weiterhin ist die Herstellung kostengünstig und das Gewicht gering. Kunststoff ist hierbei auch als synonym für Makromoleküle zu verstehen, sodass auch natürliche makromolekulare Stoffe eingeschlossen sind. Weiterhin kann der Leitungsträger aus faserverstärktem Kunststoff oder Hartpapier gefertigt sein.

Die erste Begrenzungswand bzw. die Referenzwand und die zweite Begrenzungswand können ebenfalls aus Kunststoff gefertigt sein.

Es können diese Teile einzeln gefertigt und auf die bereits erörterten Arten miteinander verbunden sind.

Als besonders vorteilhaft hat es sich jedoch erwiesen, wenn die erste Begrenzungswand bzw. die Referenzwand und die zweite Begrenzungswand, insbesondere auch der Unterstützungssteg, einteilig ausgebildet sind, insbesondere aus Stahl gefertigt sind.

So ist eine optimale Steifigkeit der Tragevorrichtung möglich, was in weiterer Folge auch eine klar definierte Position der Kontaktierung, auch unter Belastung oder insbesondere bei relativ langer Längserstreckung der Tragevorrichtung sicherstellt. Insbesondere, wenn auch der Unterstützungssteg gemeinsam mit der ersten Begrenzungswand bzw. der Referenzwand und der zweiten Begrenzungswand einteilig ausgeführt ist, wird der Leitungsträger über die gesamte Länge stabil abgestützt. Somit sind sowohl Beschädigung als auch Kontaktverlust mit den Leitungsbahnen vermieden.

Dies lässt sich besonders gut realisieren, wenn diese Komponenten aus Stahl, insbesondere aus gebogenen und evtl. verschweißten Blechen gefertigt sind. Diese Ausführungsform bietet nicht nur ausreichend Stabilität, sondern ermöglicht auch eine einfache und kostengünstige Fertigung.

In den meisten Fällen muss das elektronische Gerät an die Tragevorrichtung gekoppelt werden, um ein ungewolltes Herausfallen oder Entnehmen zu vermeiden. Dies kann beispielsweise dadurch erreicht werden, dass die Abmessungen der Tragevorrichtung und die Abmessungen des elektronischen Gerätes so gewählt werden, dass diese im zusammengesetzten Zustand kraftschlüssig miteinander verbunden sind. Hierfür können beispielsweise der Leitungsträger und die erste Begrenzungswand bzw. die Referenzwand so bemessen sein, dass sie auf das eingeführte elektronische Gerät einen Druck ausüben, der dieses zufolge von Reibung in der gewünschten Position hält.

Gemäß einer bevorzugten Ausbildungsform weist jedoch die erste Begrenzungswand bzw. die Referenzwand der Tragevorrichtung entlang ihrer Längserstreckung im Raster angeordnete Ausnehmungen, insbesondere die erste Begrenzungswand bzw. die Referenzwand durchdringende Öffnungen, auf, die zur kraftschlüssigen und/oder formschlüssigen Kopplung mit Befestigungsmitteln eines elektronischen Geräts bestimmt sind.

Solche Befestigungsmittel können so realisiert sein, dass das elektronische Gerät an der Rückwand Befestigung-Gehäuseöffnungen aufweist und einen, bevorzugt manuell, betätigbaren Befestigungsmechanismus aufweist. Der Befestigungsmechanismus weist zumindest zwei bewegliche Befestigung-Haken oder -Nasen auf, die im unbetätigten Zustand durch die Befestigungs-Gehäuseöffnung herausragen und bei Betätigung des Befestigungsmechanismus ihre Position verändern.

Die Ausnehmungen können hierbei wesentlich breiter als die Befestigung-Haken oder -Nasen sein, was eine in weiten Bereichen stufenlose Positionierung des elektronischen Geräts entlang der Tragevorrichtung erlaubt.

Bevorzugt sind die Ausnehmungen ungefähr so breit wie die Befestigung-Haken bzw. Befestigung-Nasen. Dies erlaubt eine exakte Positionierung der elektronischen Geräte entlang der Tragevorrichtung im Rastermaß. Es vereinfacht auch die Positionierung mehrerer elektronischer Geräte in gleichen Abständen entlang der Tragevorrichtung. Somit ist beispielsweise eine schnellere Bestückung eines Regals mit elektronischen Anzeigen und anderen elektronischen Geräten möglich, weil nicht extra nachgemessen werden muss, ob die Geräte gleichmäßig positioniert sind.

Ein relativ feines Raster ermöglicht zudem eine fein abgestufte Positionierung, gibt also ähnlich viel Gestaltungsfreiheit wie die stufenlose Variante, während gleichzeitig eine exakte Positionierung unter Einhaltung definierter Minimalabstände ohne ein Nachmessen möglich ist.

Insbesondere stellt die relativ feine und im Wesentlichen sich über die gesamte Länge der Tragevorrichtung erstreckende Rasterung sicher, dass die dort befestigten Geräte nicht ungewollt entlang der Tragevorrichtung verschoben werden können.

Als besonders vorteilhaft hat es sich zudem erwiesen, wenn die Rasterung bzw. die Abmessung der Ausnehmungen so bemessen und auf die Abmessungen bzw. Anordnung der Befestigung-Haken oder -Nasen abgestimmt sind, dass Geräte mit unterschiedlicher Breite (gemessen in Richtung der Längserstreckung der Tragevorrichtung) möglichst dicht an der Tragevorrichtung positioniert werden können, um den dort zur Verfügung stehenden Bestückungsbereich optimal ausnützen zu können.

Bevorzugt weist der Befestigungsmechanismus des elektronischen Geräts, insbesondere der elektronischen Anzeigeeinheit, einen manuell betätigbaren Knopf auf, der mit den Befestigung-Haken oder -Nasen gekoppelt ist, besonders bevorzugt mit den Befestigung-Haken oder - Nasen einteilig ausgebildet ist, und der an jener der Längsträger-Nut gegenüberliegenden Seitenwand frei zugänglich ist.

Ein solcher Knopf erlaubt eine einfache Bedienung und schnelle Entnahme der elektronischen Geräte. Damit geht eine schnelle und einfache Wartung oder Vertragung der Geräte einher. Die Entnahme ist hier insbesondere ohne Spezialwerkezug möglich.

Die Bedienung des Knopfes kann je nach Ausbildungsform dazu führen, dass die Befestigung-Haken oder -Nasen in das elektronische Gerät einklappen, sich in Einschieberichtung verschieben, oder beides. In allen Fällen führt die Betätigung des Knopfes und die damit einhergehende Bewegung der Befestigung-Haken oder -Nasen dazu, dass das elektronische Gerät aus der Tragevorrichtung entnommen werden kann.

Eine einteilige Ausbildung der Befestigungsmittel des Geräts kombiniert die Befestigung-Haken oder -Nasen und den Knopf, wobei die Befestigung-Haken oder -Nasen direkt in die Ausnehmungen eingreifen.

Demgegenüber kann eine zweiteilige oder mehrteilige Ausbildungsform der Befestigungsmittel des Geräts so realisiert sein, dass die rückwärtige Gehäusewand die im Raster (oder im Vielfachen des Rastermaßes) der Ausnehmungen angeordneten Befestigung-Haken oder - Nasen aufweist. Insbesondere ist die rückwärtige Gehäusewand mit den (insbesondere zwei Stück im Rasterabstand oder gemäß einem Vielfachen des Rasterabstands angeordneten) Befestigung-Haken oder -Nasen einteilig ausgebildet. Hierbei sind die erwähnte Befestigung-Gehäuseöffnungen durch einen U-förmigen Spalt gebildet, der die als Gehäusewand-Steg ausgebildeten Befestigung-Haken oder -Nasen begrenzt.

In der kraftmäßig entspannten Ruheposition ragen die Befestigung-Haken oder -Nasen so weit in die Ausnehmungen der Tragevorrichtung hinein, dass das Gerät dort gehalten wird. Bevorzugt sind zwei Befestigung-Haken oder -Nasen vorgesehen, die mit ausreichend Abstand in Bezug auf die Mitte der rückwärtigen Gehäusewand einerseits zur linke und andererseits zur rechten Seite der rückwärtigen Gehäusewand angeordnet sind.

Der Knopf kann zwecks Freigabe des elektronischen Geräts von der Tragevorrichtung eine zu der Anzahl der Befestigung-Haken oder -Nasen korrespondierende Anzahl und korrespondierend zu ihren Positionen positionierte Betätigungsfortsätze aufweisen. Diese Betätigungsfortsätze sind so geformt, dass sie bei Betätigung des Knopfes ein Einschwenken der Befestigung-Haken oder -Nasen in Richtung des Gehäuseinneren des Gerätes bewirken, so dass das Gerät aus der Tragevorrichtung entnommen werden kann. Sobald der Knopf losgelassen wird schwenken die Befestigung-Haken oder -Nasen auf Grund der Elastizität des Gehäusematerials und/oder der Elastizität des Befestigung-Haken- bzw. Befestigung-Nasen-Materials und/oder einer entsprechend wirkenden Feder wieder in ihre Ruheposition.

Um das Zusammenwirken der Befestigung-Haken oder -Nasen und der Betätigungsfortsätze zu begünstigen, können diese Abgeschrägte Enden aufweisen, so das ihre Enden de facto entlang einer schiefen Ebene aneinander vorbegleiten können und dabei Kraft aufeinander ausüben, die zum Bwegung der Befestigung-Haken oder -Nasen führt.

Gemäß einer bevorzugten Ausbildungsform weist der Befestigungsmechanismus ein Befestigungsmechanismus-Federelement auf, das den Knopf im unbetätigten Zustand in einer ersten Position hält.

Mit dem unbetätigten Zustand ist hierbei jener Zustand gemeint, bei dem das elektronische Gerät erfindungsgemäß in der Tragevorrichtung sitzt, also nicht gerade hinein- oder herausgenommen wird. In Bezug auf den Knopf bedeutet der unbetätigte Zustand, dass der Knopf nicht gedrückt ist.

Dieses Befestigungsmechanismus-Federelement sorgt nicht nur für eine einfache Bedienung, sondern stellt auch sicher, dass zwecks Entnahme des Geräts aus der Tragevorrichtung eine zielgerichtete Krafteinwirkung auf den Knopf vorliegen muss, die so stark ist, dass die Federkraft, ggf. zuzüglich einer Reibungskraftkomponente überwunden wird. Ein unbeabsichtigtes Herauslösen des Geräts aus der Tragevorrichtung durch z.B. seitliche Krafteinwirkung auf das Gehäuse, also nicht auf den Knopf, ist somit unterbunden.

Die Tragevorrichtung ist gemäß einer bevorzugten Ausbildungsform so ausgebildet, dass in Bezug auf jene Seite der ersten Begrenzungswand, die hin zum Aufnahmebereich orientiert ist, zwischen der ersten Begrenzungswand (bzw. der Referenzwand oder der Referenzseite) und der zweiten Begrenzungswand ein spitzer Winkel, insbesondere ein Winkel in einem Bereich von 35° bis 85°, ausgebildet ist.

Durch den spitzen Winkel ist sichergestellt, dass das Gerät nicht mehr nach vorne oder nach unten aus der Tragvorrichtung herausfallen kann, sobald das elektronische Gerät mit dem Befestigungsmechanismus in der Tagevorrichtung verspreizt ist.

Bevorzugt weist die zweite Begrenzungswand einen entlang der Längserstreckung verlaufenden Randbereich auf, der hin zu dem Aufnahmebereich orientiert ist, bevorzugt nasen- bzw. hakenförmig ausgebildet ist, besonders bevorzugt gekrümmt ausgebildet ist.

Dies bedeutet, dass die zweite Begrenzungswand einen Randbereich aufweist, der bei bestimmungsgemäßer Verwendung jene Kante des elektronischen Geräts, die im eingesetzten Zustand am nächsten bei der zweiten Begrenzungswand ist, nach vorne hin abstützt. In diesem Kontext bedeutet "nach vorne hin" die Richtung von der ersten Begrenzungswand zum elektronischen Gerät hin. Der Randbereich fasst also das elektronische Gerät an einer vorderen Gehäusekante und hält es dort geschützt unterhalb der zweiten Begrenzungswand.

Der spitze Winkel erlaubt es, die äußerste, obere Kante des Geräts zu fassen und das Gerät dort gehalten unter Wirkung der Befestigung-Haken oder -Nasen gegen die erste Begrenzungswand zu verspreizen.

Weiterhin hat der das Gerät übergreifende Randbereich eine schützende Wirkung gegenüber Gegenständen, die auf dem Regal abgelegt werden oder über die vordere Kante des Regals eingeschoben bzw. entnommen werden.

Der Winkel sowie die Abmessungen der zweiten Begrenzungswand sind also bevorzugt so gewählt bzw. aufeinander abgestimmt, dass das elektronische Gerät sicher an bzw. bei dessen Frontwand mit dem Randbereich der Tragevorrichtung kontaktiert und so in Position gehalten werden kann.

Die zweite Begrenzungswand muss nicht weitestgehend linear verlaufen und einen konstanten Querschnitt aufweisen. Bei Ausbildungsformen mit komplexeren Formverläufen der zweiten Begrenzungswand kann der Winkel als jener Winkel zwischen der von der ersten Begrenzungswand aufgespannten Ebene und der Ebene zwischen der Schnittgeraden der ersten Begrenzungswand und der zweiten Begrenzungswand und dem Randbereich der zweiten Begrenzungswand verstanden werden.

Ein weiterer Aspekt der Erfindung betrifft die korrekte Ausrichtung des elektronischen Geräts beim Einsetzen in die Tragevorrichtung. Um dies zu gewährleisten hat es sich als vorteilhaft erwiesen, dass die erste Begrenzungswand der Tragevorrichtung, insbesondere in einem durch den Leitungsträger überspannten Bereich, eine Struktur aus Begrenzungswand-Rippen und dazwischen liegenden Begrenzungswand-Schluchten aufweist, die zum Zusammenwirken mit einer Struktur von Gehäuse-Rippen und dazwischen liegenden Gehäuse-Schluchten des Gehäuses des Geräts zwecks Herstellung einer Sollorientierung des elektronischen Geräts bei einem bestimmungsgemäßen Einsetzen des elektronischen Geräts in die Tragevorrichtung vorgesehen sind. Auch das elektronische Gerät weist an dem Gehäuse eine Struktur aus Gehäuse-Rippen und dazwischen liegenden Gehäuse-Schluchten auf, die zum Zusammenwirken mit Begrenzungswand-Rippen und dazwischen liegenden Begrenzungswand-Schluchten der ersten Begrenzungswand zwecks Herstellung besagter Sollorientierung des elektronischen Geräts bei einem bestimmungsgemäßen Einsetzen des elektronischen Geräts in die Tragevorrichtung vorgesehen sind.

Zweckmäßigerweise verlaufen die Strukturen geradlinig und erstrecken sich einerseits im rechten Winkel in Bezug auf die Längserstreckung der Tragevorrichtung bzw. andererseits im rechten Winkel in Bezug auf den Verlauf der Leitungsträger-Nut.

Diese aufeinander abgestimmten Strukturen bewirken beim Einsetzen des elektronischen Geräts in die Tragevorrichtung die Herstellung einer Sollorientierung des elektronischen Geräts an der Tragevorrichtung. Damit sind Fehlkontaktierungen der Leitungsbahnen, die ggf. zu Fehlfunktionen oder sogar Kurzschlüssen zwischen den Leitungsbahnen führen könnten, zuverlässig vermieden.

Die Länge der Strukturen definiert jene Position entlang der Einsetzbewegung, ab der die Sollorientierung hergestellt wird. Da sich die Leitungsbahnen entlang des Leitungsträgers erstrecken, hat es sich als besonders vorteilhaft erwiesen, dass sich auch die Länge der Strukturen an der Abmessung des Leitungsträgers gemessen entlang der Richtung normal auf die Längserstreckung des Leitungsträgers und parallel zu der Ebene der ersten Begrenzungswand orientiert. Dies sollte als Mindestmaß vorgesehen sein, um bereits beim Annähern des elektronischen Geräts an den Leitungsträger oder erst beim erstmaligen Berühren des Leitungsträgers durch das elektronische Gerät die Sollorientierung herzustellen.

Die Breite der Strukturen entspricht bevorzugt im Wesentlichen dem Rastermaß der Ausnehmungen entlang der Längserstreckung der Tragevorrichtung.

Abschließend sei noch erwähnt, dass in einer bevorzugten Ausbildungsform die Ausnehmungen wie auch die dazwischenliegende Materialstege der Tragevorrichtung identische Breiten aufweisen, die genau dem Rastermaß entsprechen, sodass sich eine periodische Abfolge von Aussparungen und Materialstegen entlang der Längserstreckung der Tragevorrichtung ergibt.

Die Tragevorrichtung kann also insgesamt kompakter ausgeführt werden, sodass sie einen geringeren Sichtbereich vor den Produkten bzw. dem Regalboden abdeckt. Ein solches schmaleres Erscheinungsbild lässt nicht nur das System hochwertig erscheinen, sondern ermöglicht auch einen besseren Blick auf die Waren, die sich hinter der Tragevorrichtung befinden.

Diese und weitere Aspekte der Erfindung ergeben sich durch die nachfolgend erörterten Figuren.

### Figurenkurzbeschreibung

Die Erfindung wird im Folgenden unter Hinweis auf die beigefügten Figuren anhand von Ausführungsbeispielen noch einmal näher erläutert, auf welche die Erfindung jedoch nicht beschränkt ist. Dabei sind in den verschiedenen Figuren gleiche Komponenten mit identischen Bezugszeichen versehen. Es zeigen auf schematische Weise:
- Fig. 1: eine erfindungsgemäße Tragevorrichtung ausgeführt als Regalschiene im Querschnitt und eine an ihr positionierte erfindungsgemäße elektronische Anzeigeeinheit,
- Fig. 2: die an der Regalschiene befestigte elektronische Anzeigeeinheit,
- Fig. 3: eine rückseitige Ansicht eines Bereichs der Regalschiene mit Ausnehmungen in einem Raster,
- Fig. 4: eine rückseitige Ansicht der elektronischen Anzeigeeinheit gemäß einem ersten Ausführungsbeispiel,
- Fig. 5: eine Seitenansicht der elektronischen Anzeigeeinheit,
- Fig. 6A: eine elektrische Kontaktierung von Kontakten der elektronischen Anzeigeeinheit und Drähten der Regalschiene,
- Fig. 6B: ein metallisches Kontaktband der elektronischen Anzeigeeinheit,
- Fig. 7: ein Ausführungsbeispiel einer Regalschiene mit Unterstützungssteg,
- Fig. 8: eine weiteres Ausführungsbeispiel einer Regalschiene mit Unterstützungssteg,
- Fig. 9: eine seitlich in die Regalscheine eingesetzte Versorgungseinrichtung mit größtenteils freigeschnittenem Gehäuse,
- Fig. 10: die elektronische Verbindung zwischen der Regalschiene und der Versorgungseinrichtung in einer Ansicht ohne ihr Gehäuse,
- Fig. 11: eine magnetisch an dem Regal angebrachte Batterieeinheit zur Versorgung der Elektronik der Regalschien,
- Fig. 12: eine Zusammenschau aus Regalschiene und zwei Anzeigeeinheiten,
- Fig. 13: eine rückwärtige Ansicht der Regalschiene mit eingesetzter Versorgungseinrichtung,

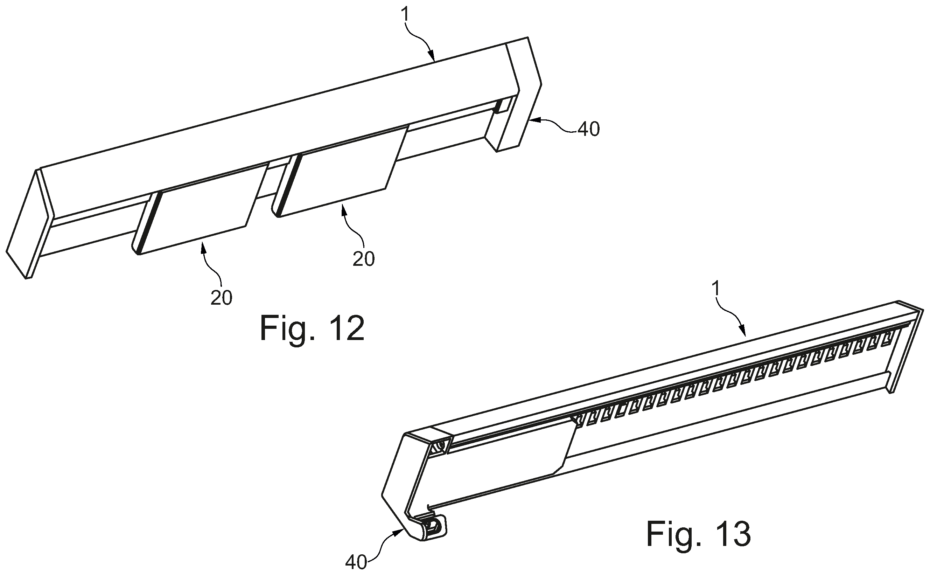

- Fig. 12 - 13: Details einer zweiten Ausbildungsform der Anzeigeeinheit,

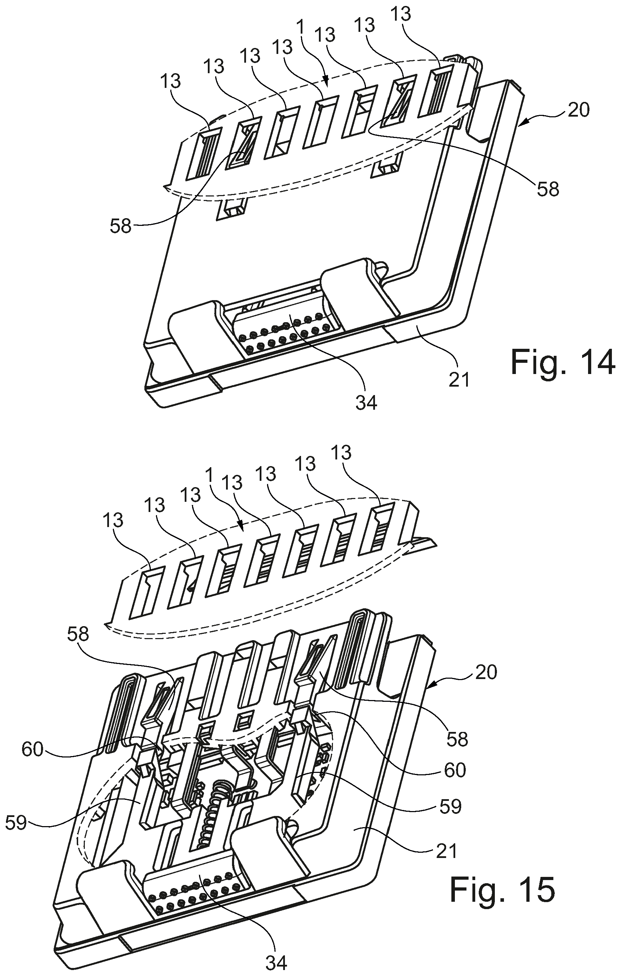

- Fig. 14 - 17: eine zweite Ausbildungsform der Anzeigeeinrichtung.

### Beschreibung der Ausführungsbeispiele

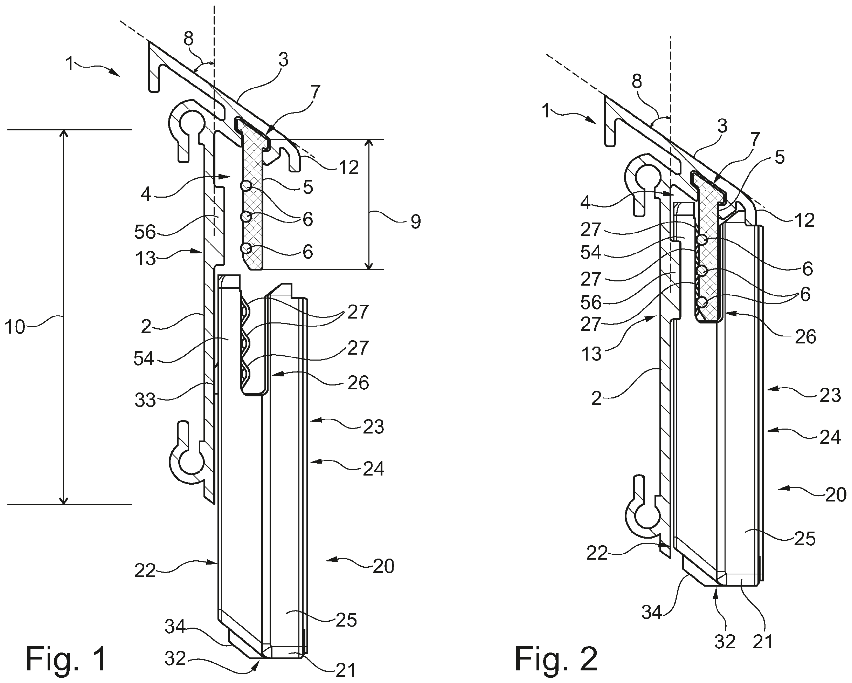

Die Figur 1 zeigt eine Tragevorrichtung realisiert als Regalschiene 1 und ein mit der Regalschiene 1 kompatibles Gerät beispielshaft realisiert als eine elektronische Anzeigeeinheit 20 in einer seitlichen Betrachtungsrichtung, wobei die Regalschien 1 in einem Schnitt entlang einer Schnittfläche benachbart zu der Anzeigeeinheit zu sehen ist.

Die Regalschiene 1 weist eine erste Begrenzungswand 2 (Referenzwand 2) auf, die in der Abbildung vertikal dargestellt ist.

An ihrem oberen Ende geht die erste Begrenzungswand bzw. Referenzwand 2 in eine zweite Begrenzungswand 3 über. Die zweite Begrenzungswand 3 und die Referenzwand 2 sind in diesem Ausführungsbeispiel einteilig aus Stahl gefertigt.

Zwischen der Referenzwand 2 und der zweiten Begrenzungswand 3 befindet sich ein durch diese Wände 2 und 3 zweiseitig begrenzter Aufnahmebereich 4 zum Aufnehmen der Anzeigeeinheit 20.

Auf der Seite der Anzeigeeinheit 20, also im Raumbereich des Aufnahmebereichs 4 gemessen, ist zwischen der Referenzwand 2 und der zweiten Begrenzungswand 3 ein spitzer Winkel 8 mit etwa 53° gebildet.

Die zweite Begrenzungswand 3 weist einen Aufnahme-Schacht 7 auf, in dem ein Leitungsträger 5 eingesetzt ist, der als Leitungsträgerplatte ausgeführt ist. Der Leitungsträger 5 ist an jener Seite, die in den Aufnahme-Schacht 7 eingeschoben ist, an die Form des AufnahmeSchachts 7 angepasst, also im Wesentlichen T-förmig ausgebildet. Der Leitungsträger 5 ist in dem Aufnahme-Schacht 7 normal auf die Bildebene der Figur 1 aus dieser heraus bzw. in diese hinein verschiebbar, um ihn dort einzusetzen oder auch von dort zu entnehmen.

Der Leitungsträger 5 trägt drei Leitungsbahnen 6. Die Leitungsbahnen 6 sind jeweils aus einem einadrigen Kupferdraht 6 gefertigt und sind isolationsschichtfrei ausgeführt. Mehr als 50 % des Querschnitts der Drähte 6, etwa zwei Drittel der radialen Abmessung, sind im Leitungsträger 5 eingebettet. Hierbei ist jener Draht 6, der sich am nächsten bei der zweiten Begrenzungswand 3 befindet die Leistungsversorgungsleitung, die mittlere Leitungsbahn 6, die Signalversorgungsleitung und die Leitungsbahn 6, die am weitesten von der zweiten Begrenzungswand 3 entfernt ist, die Bezugspotenzialleitung. Die Drähte 6 sind auf jener der Referenzwand 2 zugwandten Seite des Leitungsträgers 5 angeordnet.

Der Leitungsträger 5 und die Referenzwand 2 weisen jeweils eine erste Abmessung (Längserstreckung) auf, die das Längenmaß gemessen aus der Bildebene heraus bzw. in die Bildebene hinein repräsentiert, wobei in diesem Ausführungsbeispiel beide gleich groß sind und beispielhaft etwa 1,5 m lang sind. Es können aber auch andere Länge für die Regalschiene 1 vorgesehen sein.

Der Leitungsträger 5 weist eine zweite Abmessung 9 (Höhe) auf, die in der Figur 1 die vertikale Ausdehnung des Leitungsträgers 5 repräsentiert. Dazu korrespondierend weist die Referenzwand 2 eine dritte Abmessung 10 (Höhe) auf, welche die vertikale Ausdehnung der Referenzwand 2 in Figur 1 angibt. In diesem Ausführungsbeispiel beträgt die zweite Abmessung 9 des Leitungsträgers 5 etwa 40 % der dritten Abmessung 10 der Referenzwand 2. Die zweite Abmessung 9 beträgt bei diesem Ausführungsbeispiel beispielhaft etwa 3 cm.

Der Leitungsträger 5 ist in diesem Ausführungsbeispiel aus isolierendem Polypropylen mittels Spritzgussverfahren hergestellt, wobei die Drähte 6 bereits beim Herstellungsverfahren des Leitungsträgers 5 eingebettet wurden.

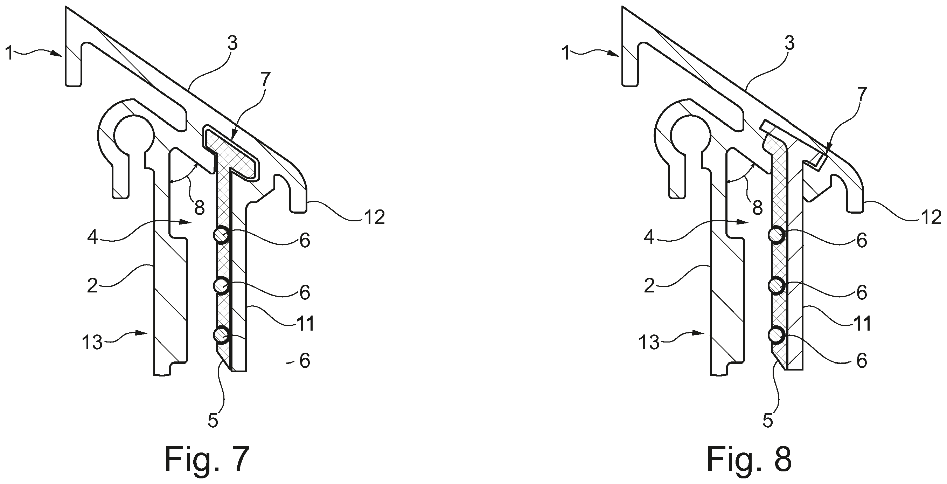

Im vorliegenden Fall ist der Leitungsträger 5 freistehend angeordnet. Demgegenüber sind in den Figuren 7 und 8 Ausführungsbeispiele mit einem Unterstützungssteg 11 dargestellt. In der Figur 7 ist der Unterstützungssteg 11 mit der zweiten Begrenzungswand 3 stoffschlüssig verbunden und die Referenzwand 2, die zweite Begrenzungswand 3 und der Unterstützungssteg 11 bilden zusammen einen Bauteil. Sie sind also einteilig ausgebildet. In der Figur 8 ist der Unterstützungssteg 11 als eigenständiges Teil ausgeführt und dazu ausgebildet, gemeinsam mit dem Leitungsträger 5 in den Aufnahme-Schacht 7 aufgenommen, bzw. geschoben zu werden.

Die zweite Begrenzungswand 3 weist - wie in den Figuren 1, 2, 7 und 8 sichtbar - endseitig einen nasen- bzw. hakenförmig ausgebildeten Randbereich 12 auf, der bei eingesetzter Anzeigeeinheit 20 verhindert, dass diese in die Normalenrichtung bezogen auf die Referenzwand 2 von der Referenzwand 2 wegbewegt werden kann.

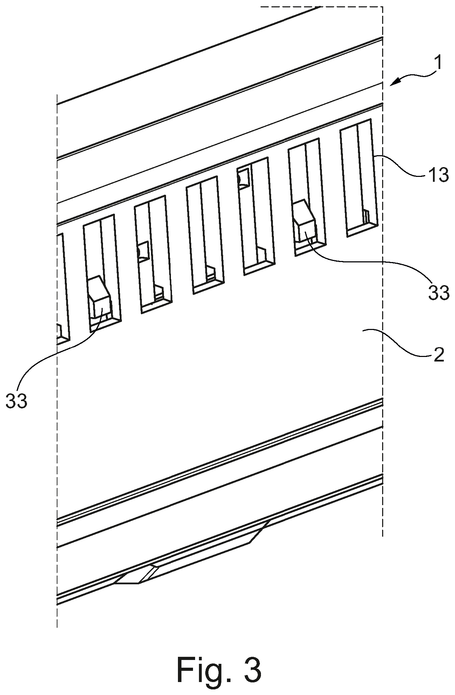

Die Referenzwand 2 weist im Raster angeordnete Ausnehmungen 13 auf, die in der Figuren 3 dargestellt sind und zur Befestigung der Anzeigeeinheit 20 dienen, worauf nachfolgend noch eingegangen ist.

Die Anzeigeeinheit 20 ist in Figur 1 so positioniert, dass sie mit einer geradlinigen Bewegung parallel zur Referenzwand 2 von unten her in die Regalschiene 1 in Richtung der zweiten Begrenzungswand 3 eingeschoben werden kann.

Die Anzeigeeinheit 20 weist ein Gehäuse 21 mit einer Rückwand 22 auf. Die Rückwand 22 stellt hierbei jenen Teil des Gehäuses 21 dar, der sich wie in den Figuren 2 ersichtlich im in die Regalschiene 1 eingesetzten Zustand am nächsten an der Referenzwand 2 befindet. Auf der Seite gegenüber der Rückwand 22 befindet sich eine Frontwand 23, die einen Bildschirm 24 aufweist. Die Frontwand 23 weist an ihrem oberen Ende eine Stufe auf, die zur Aufnahme des Randbereichs 12 der Regalschiene 1 ausgebildet ist. Zwischen der Frontwand 23 und der Rückwand 22 wird das Gehäuse 21 durch eine Seitenwand 25 gebildet. Die entlang der Oberseite der Anzeigeeinheit 20 verlaufende Seitenwand 25 weist eine Leitungsträger-Nut 26 auf, deren vertikale Wände im Wesentlichen parallel zur Rückwand 22 verlaufen. Die Leitungsträger-Nut 26 ist zur Aufnahme des Leitungsträgers 5 vorgesehen und an seine Abmessungen angepasst dimensioniert.

Das Gehäuse 21 hat in der Leitungsträger-Nut 26 rückwandseitig Gehäuseöffnungen durch die Kontakte 27 aus dem Gehäuse 21 heraus in die Leitungsträger-Nut 26 hineinragen. Die Kontakte 27 sind durch eine Gruppe metallischer Kontaktbänder 27 realisiert.

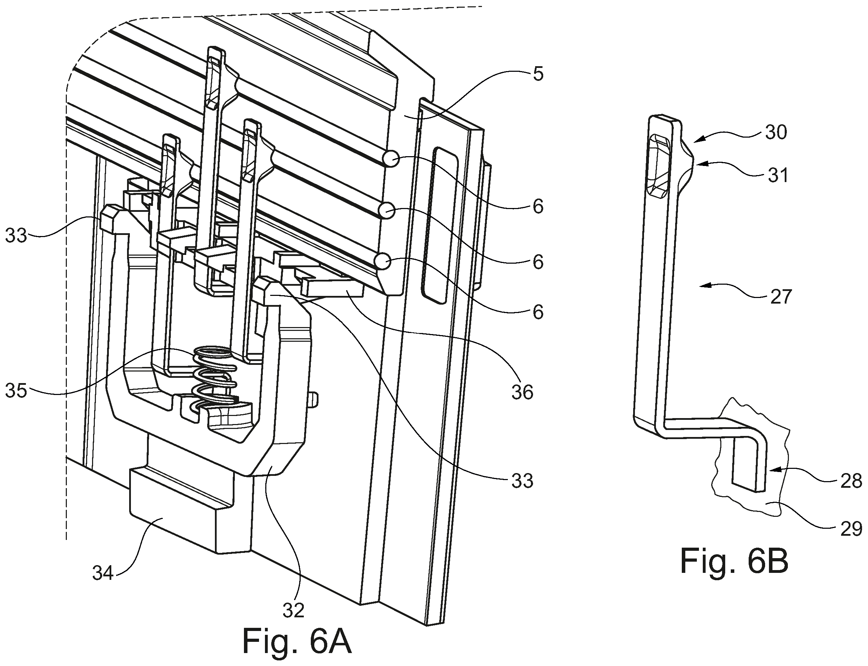

Die metallischen Kontaktbänder 27 sind detaillierter in Figur 6A und Figur 6B dargestellt. Die Figur 6B zeigt den Aufbau bzw. die Form eines Kontaktbandes 27, das einen ersten Endabschnitt 28 aufweist, der an einer nur ausschnittsweise dargestellten Gerät-Elektronik bzw. Anzeigeelektronik 29 angelötet ist. Weiterhin weist das Kontaktband 27 einen zweiten Endabschnitt 30 auf, der für die Kontaktierung mit einem der Drähte 6 ausgebildet bzw. geformt ist, so wie dies in Figur 6A dargestellt ist.

Der zweite Endabschnitt 30 weist eine erhabene Form 31 als Kotaktzone auf. Diese erhabene Form 31 ist auch jener Teil der metallischen Kontaktbänder 27, die in Figur 1 und 2 in der seitlichen Ansicht der Anzeigeeinheit zu sehen ist.

Wie in den Figuren 6A bzw. 6B ersichtlich, sind die beiden Endabschnitte 28, 30 in diesem Ausführungsbeispiel parallel aber versetzt angeordnet, sodass das Kontaktband 27 eine Stufe bildet. Diese Stufe ermöglicht einen größeren Federweg und eine Verteilung der Biegebelastung auf das federnde Material. Zugleich überwindet sie den Abstand (Niveauunterschied) zwischen der Ebene der Anzeigeelektronik 29 und der Ebene der Kontaktierung, welche durch die Drähte 6 aufgespannt ist.

Der Übersichtlichkeit wegen sind eine Vielzahl der Komponenten der elektronischen Anzeigeeinheit 20 in der Figur 6A nicht dargestellt, um den Blick auf einen Befestigungsmechanismus 32 freizugeben. Der Befestigungsmechanismus 32 ist einteilig ausgeführt und weist zwei Befestigung-Haken 33 und einen damit verbundenen Knopf 34 auf. Der Befestigungsmechanismus 32 steht außerdem mit einem als Schraubenfeder ausgeführten Federelement 35 in Kontakt.

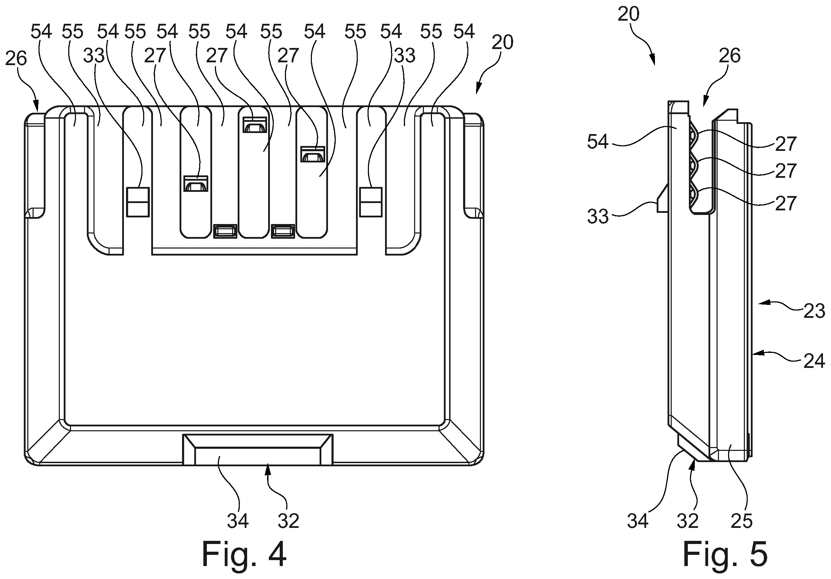

Wie in der Figur 4 und 5 sichtbar, weist die Rückwand 22 Befestigung-Gehäuseöffnungen auf, durch welche die Befestigung-Haken 33 herausragen.

Weiterhin zeigt die Figur 6A ein Gehäuse-Verbindungselement 36, das beide Gehäusehälften (die vordere und die hintere Gehäusehälfte des Gehäuses 21) mittels Steckverbindung bzw. Klammerverbindung miteinander verbindet.

Das Federelement 35 liegt mit der in Figur 6A frei dargestellten Seite mit Vorspannung auf dem Gehäuse 21 auf. Das Federelement 35 wirkt also zwischen dem Befestigungsmechanismus 32 und dem Gehäuse 21. Daher drückt es den Befestigungsmechanismus 32 und damit die Befestigung-Haken 33 und den Knopf 34 parallel zur Rückwand 22 in der Orientierung der Figur 6A nach unten von der Leitungsträger-Nut 26 weg.

Wird nun die elektronische Anzeigeeinheit 22 ausgehend von der in Figur 1 dargestellten Anordnung, parallel zur Referenzwand 2 in Richtung der zweiten Begrenzungswand 3 geschoben, sodass die Anzeigeeinheit 22 abschließend wie in Figur 2 dargestellt in der Regalschienen 1 positioniert und fixiert ist, berühren die Endabschnitte 30 der Kontaktbänder 27 die Drähte 6.

Zu erwähnen sei hier noch, dass der Leitungsträger 5 an diesem freien Ende eine zur ersten Begrenzungswand bzw. der Referenzwand 2 hin orientierte Fase aufweist, die sicherstellt, dass die erhabene Form 31 der Kontaktbänder 27 problemlos auf die Ebene der Drähte 6 angehoben wird, wenn die Anzeigeeinheit 22 in ihre Sollposition an der Regalschiene 1 von unten her eingeschoben wird. Jedes Kontaktband 27 wird dabei vorgespannt. Beim weiteren Einschieben in die Regalschiene 1 gleiten zumindest zwei der drei Kontakte mit ihren erhabenen Kontaktzonen über zwei der Drähte 6 hinweg, bis dass alle drei Kontakte mit ihren erhabenen Kontaktzonen letztendlich den jeweiligen zu kontaktierenden Draht 6 erreichen und dort von dem Leitungsträger 5 abgehoben werden, also die Vorspannung intensiviert wird, was zu einer optimalen elektrischen Kontaktierung der Drähte 6 beiträgt.

Weiterhin sei erwähnt, dass beim Einschieben der Anzeigeeinheit 20 in die Regalschiene 1 die Befestigung-Haken 33 an der Referenzwand 2 entlang gleiten, bis sie die Ausnehmungen 13 der Referenzwand 2 erreichen, in denen sie sich automatisch verhaken. In der Figur 3 sieht man wie die Anzeigeeinheit 20 gerade in die Regalschiene 1 eingesetzt bzw. von ihr entnommen wird, weil die Befestigung-Haken 33 etwas von den unteren Kanten der Ausnehmungen 13 entfernt sind. Im eingesetzten Zustand berühren diese die untere Kante der Ausnehmungen 13, also jene Kante, die am weitesten von der zweiten Begrenzungswand 3 entfernt ist. Die in der Figur 3 dargestellten Ausnehmungen 13 sind in etwa so breit wie bzw. geringfügig breiter als die Befestigung-Haken 33. Dies schafft ein feines, aber wohl definiertes Raster, sodass die elektronischen Anzeigeeinheiten 20 nicht mehr kontinuierlich entlang der Regalschiene 1 verschiebbar sind, sondern an klar definierten Stellen positionierbar sind.

Wie in der Figur 6A ersichtlich wirkt im Inneren der Anzeigeeinheit 1 das Federelement 35 einerseits auf das Gehäuse 21 und andererseits auf den Befestigungsmechanismus 32, sodass der Befestigung-Haken 33 gegen die untere Kante der Ausnehmung 13 der Rückwand 2 gedrückt wird, wodurch die elektronische Anzeigeeinheit 20 in Richtung der zweiten Begrenzungswand 3 nach oben gedrückt wird. Wie in der Figur 2 zu sehen ist, liegt die untere Kante bzw. Seite des Leitungsträgers 5, also jene Seite des Leitungsträgers 5, die am weitesten von der zweiten Begrenzungswand 3 entfernt ist, an der tiefsten Stelle in der Leitungsträger-Nut 26 auf, sodass eine klar definierte mechanische Kontaktstelle zwischen der elektronischen Anzeigeeinheit 20 und der Regalschiene 1 entsteht. Zwei weitere solcher definierten Kontaktstellen befinden sich zwischen dem Randbereich 12 und der oberen Kante der Frontwand 23 und zwischen der Referenzwand 2 und jenem Bereich der Rückwand 22, der im Bereich der Drähte 6 verläuft. Diese definierten Kontaktstellen ermöglichen im zusammengesteckten Zustand eine eindeutige Festlegung der körperfesten Punkte der elektronischen Anzeigeeinheit 20 in Bezug zur Regalschiene 1 und umgekehrt. Es wird also beim Einsetzen der Anzeigeeinheit 20 in die Regalschiene 1 durch die Federwirkung des Federelements 35 die Anzeigeeinheit 20 reproduzierbar und auf automatische Weise immer gleich bzw. immer optimal in der Regalschiene 1 aufgenommen und ausgerichtet.

Wird nun der Knopf 34 gedrückt, wird die Verbindung der Befestigung-Haken 33 und der Referenzwand 2 gelöst, woraufhin die elektronische Anzeigeeinheit 20 nach unten hin, ggf. nach einem Absenken um die Abmessung des Leitungsträgers 5 auch nach vorne geneigt, aus der Regalschiene 1 entnommen werden kann. Bei Betätigung des Knopfes 34 bewegt sich der Befestigung-Haken 33 einerseits nach oben, also in Richtung der zweiten Begrenzungswand 3, und andererseits in die elektronische Anzeigeeinheit 20 hinein, also weg von der Referenzwand 2, wodurch die Anzeigeeinheit 20 für die Entnahme aus der Regalschien 1 freigeben wird.

Die Figur 4 zeigt die elektronische Anzeigeeinheit 20 von hinten, also mit Blick auf die Rückwand 2 schauend. In dieser Ansicht sind die Positionen der erhabenen Form 31 der metallischen Kontaktbänder 27 durch Gehäuseöffnungen der Rückwand 2 hindurch zu sehen. Dort sind sie elektronisch zu kontaktieren, sodass die Anzeigeeinheit 20 auch außerhalb der Regalschiene 1 betrieben bzw. getestet werden kann.

Weiterhin ist in Figur 4 erkennbar, dass die Rückwand 22 im besagten Raster angeordnete erhabene Gehäuse-Rippen 54 mit dazwischen liegenden Gehäuse-Schluchten 55 aufweist. Diese Strukturen 54 und 55 sind gleich breit und gerade ausgebildet und verlaufen strikt im Winkel von 90° bezogen auf die Längserstreckung der Leitungsträger-Nut 26, also in Richtung von der oberen Seitenwand 25 hin zu der unteren Seitenwand 25. Auch die Regalschiene 1 weist an ihrer ersten Begrenzungswand bzw. Referenzwand 2 im Bereich parallel zu dem Leitungsträger 5 Begrenzungswand-Rippen 56 mit dazwischen liegenden Begrenzungswand-Schluchten 57 auf. Diese Strukturen 56 und 57 sind gleich breit und gerade ausgebildet und verlaufen strikt im Winkel von 90° bezogen auf die Längserstreckung der Regalschiene 1.

Die Strukturen 56 und 57 der Regalschiene 1 sind gegenüber den Strukturen 54 und 56 des Gehäuses 25 jeweils um eine Rastereinheit versetzt, sodass die Gehäuse-Rippen 54 in Begrenzungswand-Schluchten 57 eingeführt werden können, während Begrenzungswand-Rippen 57 in Gehäuse-Schluchten 55 eingeführt werden können. Bevorzugt befindet sich die Position der Gehäuseöffnung für die Befestigung-Haken oder - Nasen 33 immer an der Position einer Gehäuse-Rippe 54.

Sie Strukturen 54 - 57 stellen sicher, dass die Anzeigeeinheit 20 beim Einschieben in die Regalschiene 1 frühzeitig möglichst exakt im rechten Winkel (90°) zu der Längserstreckung des Leitungsträgers 5 ausgerichtet ist, um Kontaktierungsfehler ggf. auch Kurzschlüsse zwischen den Drähten 6 zu vermeiden, die bei einer schräg eingesetzten Anzeigeeinheit 20 auftreten könnten.

Die Figur 5 zeigt eine Seitenansicht der elektronischen Anzeigeeinheit 20, wobei im Unterschied zu den Figuren 1 und 2 die Anzeigeeinheit 20 ohne die Regalschiene 1 dargestellt ist, also auch die Befestigung-Haken 33 zu sehen sind.

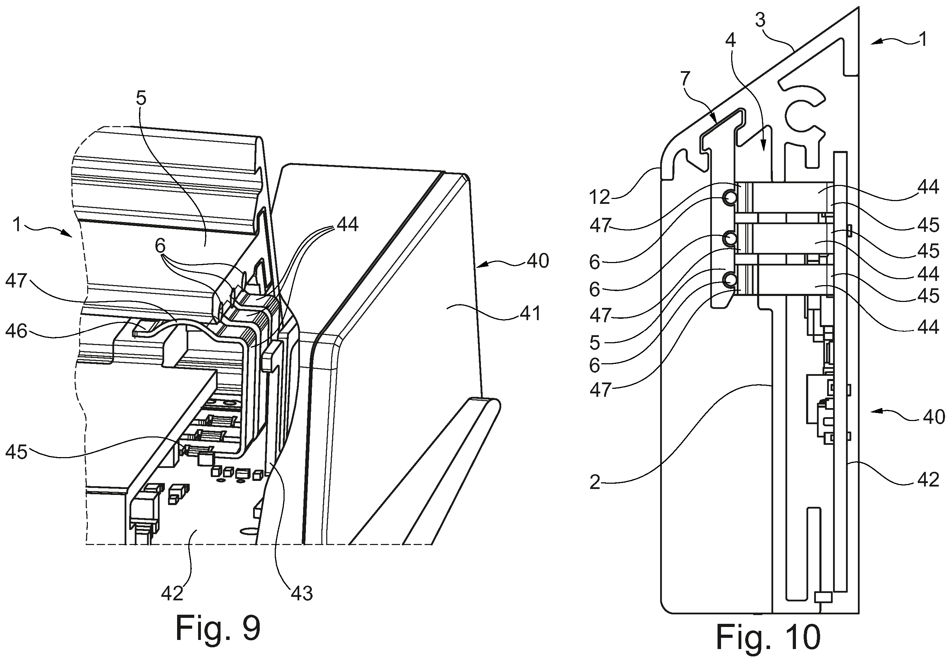

Die Figur 9 zeigt die Versorgungseinrichtung 40, die in den seitlichen Endabschnitt der Regalschiene 1 eingesetzt ist und dort mit der Regalschiene 1 gekoppelt ist.

Die Versorgungseinrichtung 40 weist ein Gehäuseteil 41 auf, das in dieser Ansicht größtenteils freigeschnitten dargestellt ist, um Sicht auf die darin befindlichen Komponenten zu gewähren. Die Versorgungseinrichtung 40 weist eine Versorgungselektronik 42 auf, zu der auch eine Antenne 43 gehört, wobei die Versorgungselektronik 42 dazu ausgebildet ist, mit Hilfe der Antenne 43 funkbasiert Daten mit einem Accesspoint auszutauschen, zu verarbeiten und mit den Geräten an der Regalschiene 1 leitungsgebunden zu kommunizieren oder diese zu steuern sowie diese mit elektrischer Leistung für ihren Betrieb zu versorgen.

Die Versorgungselektronik 42 weist Kontakte auf, die - ähnlich zu den Kontakten der Anzeigeeinrichtung 20 - als eine zweite Gruppe metallischer Kontaktbänder 44 realisiert sind. Jedes dieser Kontaktbänder 44 weist einen ersten Endabschnitt 45 auf, der mit der Versorgungselektronik 42 verlötet ist, und einen zweiten Endabschnitt 46 auf, der eine Bogenform 47 als Kontaktzone aufweist.

Der erste Endabschnitt 45 und der zweite Endabschnitt 46 sind im Wesentlichen parallel zueinander angeordnet und so miteinander verbunden, dass jedes Kontaktband 44 eine C- bzw. U-Form annimmt. Damit wird der seitliche Rand der Regalschiene 1 umgriffen, und zwar ohne, dass diese außerhalb des gewünschten Kontaktbereichs berührt wird.

Die Kontaktbänder 44 sind federnd ausgebildet und drücken mit der Bogenform 47 mit einer Vorspannung, die für eine definierte Kontaktierungskraft sorgt, gegen die Drähte 6, wobei jedes Kontaktband 44 genau einem Draht 6 zugeordnet ist.

Das Gehäuseteil 41 ist einseitig (in der Perspektive der Figur 9 an der linken Seite) offen, sodass die Versorgungseinrichtung 40 (in der Perspektive der Figur 9 von rechts her) in die Regalschiene 1 eingeschoben werden kann, wobei die Kontaktbänder 44 mit der Bogenform 47 an den Drähten 6 entlang gleiten und eine elektrisch leitende Verbindung herstellen. Die Versorgungselektronik 42 wird hinter die Referenzwand 2 der Regalschiene 1 geschoben, wo sie von Teilen der Regalschiene 1 umgeben und geschützt ist. Das Gehäuseteil 41 hat definierte Kontaktzonen, mit denen es mit der Regalschiene 1 in mechanischem Kontakt steht, um eine präzise Positionierung der Versorgungseinrichtung 40 in Bezug zu der Regalschiene 1 sicherzustellen.

Die Figur 10 zeigt die in die Regalschiene 1 eingeführte Versorgungseinrichtung 40, wobei der Übersichtlichkeit halber auf die Darstellung einiger Komponenten, wie etwa das Gehäuseteil 41 und die Antenne 43, verzichtet wurde.

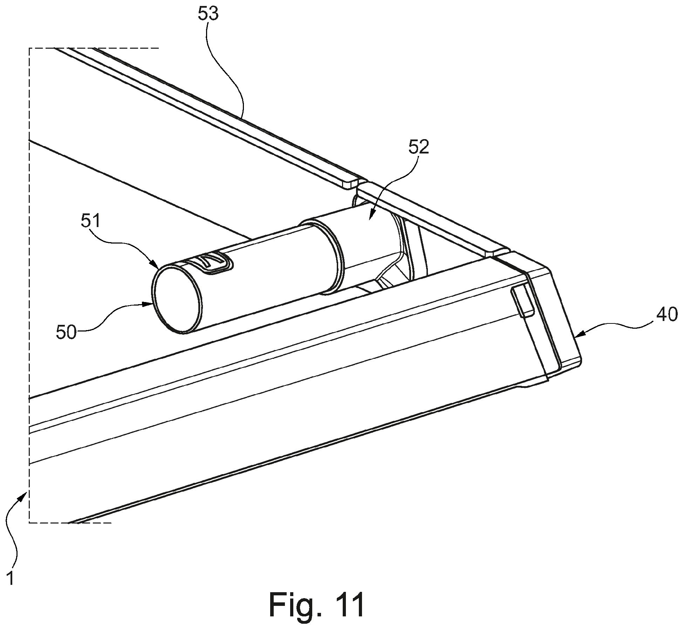

Die Figur 11 zeigt eine wieder aufladbare Akkumulator-Einheit 50, die einen Akkumulator (oder auch eine wieder aufladbare Batterie) 51 und ein Befestigungselement 52 aufweist und die mit der Versorgungseinrichtung 40 mit einem Kable (nicht dargestellt) verbunden ist. Das Befestigungselement 52 ist mit Hilfe von drei im Dreieck angeordneten Magneten realisiert und weist eine Kontaktfläche zum flächenhaften Aufsetzen auf ein aus Stahl gefertigtes Regalseitenteil 53 des Regals auf. Von diesem Regal wurde der Regalboden entfernt, um einen Blick auf die Akkumulator-Einheit 50 freizugeben.

Rechtwinkelig auf das Regalseitenteil 53 ist die Regalschiene 1 montiert.

Bei der Wartung kann die gesamte Akkumulator-Einheit 50 dank der Magnetverbindung einfach entnommen und ausgetauscht werden.

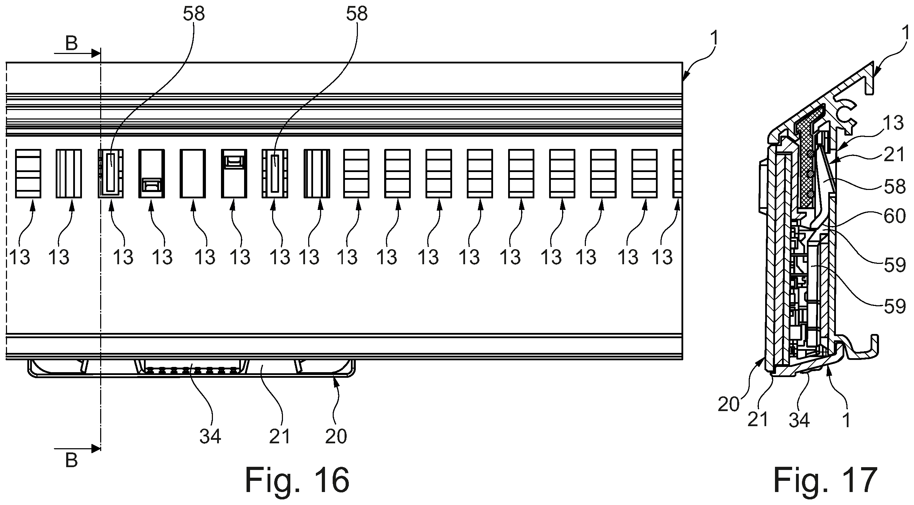

In der Figur 14 ist ein Ausschnitt der Regalschiene 1 und die Anzeigeeinheit 20 von ihrer Rückseite her zu sehen. Diese beiden Elemente 1 und 20 sind in der Figur 15 voneinander losgelöst dargestellt, wobei hier auch das Gehäuse 21 an seiner Rückwand freigeschnitten den Blick auf das Innere der Anzeigeeinheit 20 freigebend dargestellt ist. In der Figur 16 ist die Regalschiene 1 von ihrer Rückseite her mit eingesetzter Anzeigeeinheit 20 zu sehen und die Figur 17 zeigt einen Schnitt entlang der Schnittlinie BB gemäß der Figur 16. Hier sei auch erwähnt, dass aus Gründen der Übersichtlichkeit einige der Bezugszeichen in diesen Figuren nicht eingetragen sind.

Im Unterscheid zu der in den vorangehenden Figuren dargestellten Anzeigeeinheit 20 kommt hier eine mehrteilige Ausbildung der Befestigungsmittel zum Einsatz. Im vorliegenden Fall weist das Gehäuse 21 zwei Befestigung-Haken oder -Nasen 58 auf, die als Bestandteil des Gehäuses 21 realisiert sind. Diese Befestigung-Haken oder -Nasen 58 greifen in die Ausnehmungen 13 der Regalschiene 1 ein, wie in der Figuren 14, 16 und 17 deutlich zu sehen ist.

In der Figur 15 ist im Detail der Knopf 34 mit seinen zwei Betätigungsfortsätzen 59 zu sehen, die zum Betätigen der beiden Befestigung-Haken oder -Nasen 58 vorgesehen sind. Das Weitern ist in der Figur 17 zu sehen, wie die Betätigungsfortsätze 59 mit den Befestigung-Haken oder -Nasen 58 zusammenwirken, nämlich über eine in Bezug auf ihre Längserstreckung schief orientierte Ebene 60, also eine schiefe Ebene (siehe auch Figur 17), die an den jeweiligen Bauteilenden ausgebildet ist, sodass die Bauteilenden aneinander gleiten können, wenn der Knopf 34 betätigt wird. Bei Betätigung des Knopfes 34 werden die beiden Befestigung-Haken oder -Nasen 58 durch die Längsbewegung der Betätigungsfortsätze 59 in das Innere des Gehäuses gedrückt und die Verbindung zwischen der Regalschiene 1 und der Anzeigeeinheit 20 gelöst.

Es wird abschließend noch einmal darauf hingewiesen, dass es sich bei den vorangehend detailliert beschriebenen Figuren nur um Ausführungsbeispiele handelt, welche vom Fachmann in verschiedenster Weise modifiziert werden können, ohne den Bereich der Erfindung zu verlassen. Es wird der Vollständigkeit halber auch darauf hingewiesen, dass die Verwendung der unbestimmten Artikel "ein" bzw. "eine" nicht ausschließt, dass die betreffenden Merkmale auch mehrfach vorhanden sein können.

Bevorzugte Ausführungsformen der Erfindung sind in den folgenden Ausführungsbeispielen angegeben:
Beispiel 1. Tragevorrichtung (1), bevorzugt realisiert als Regalschiene, für die mechanische Befestigung eines elektronischen Geräts (20), besonders bevorzugt für die Befestigung einer elektronischen Anzeigeeinheit,
   wobei die Tragevorrichtung (1) aufweist:
      - eine erste Begrenzungswand (2), insbesondere eine Referenz.- bzw. Positionierung-Ebene definierende Referenzwand (2), an der oder benachbart zu der das elektronische Gerät, insbesondere mit seiner Rückwand (22), an der Tragevorrichtung (1) positionierbar ist, und
      - eine in einem Winkel (8) zu der ersten Begrenzungswand (2) orientierte zweite Begrenzungswand (3), wobei die erste Begrenzungswand (2) und die zweite Begrenzungswand (3), insbesondere nur zweiseitig, einen Aufnahmebereich (4) für die Aufnahme des elektronischen Geräts (20) begrenzen, und
      - einen Leitungsträger (5), der Leitungsbahnen (6) zur elektronischen Versorgung des elektronischen Geräts (20) trägt,
   dadurch gekennzeichnet,
   dass der Leitungsträger (5) in einem Abstand von der ersten Begrenzungswand (2) ausgehend von der zweiten Begrenzungswand (3), insbesondere parallel zu der ersten Begrenzungswand (2), in den Aufnahmebereich (4) hineinragt.
Beispiel 2. Tragevorrichtung (1) nach Beispiel 1, wobei der Leitungsträger (5) als Leitungsträgerplatte ausgebildet ist.
Beispiel 3. Tragevorrichtung (1) nach Beispiel 2, wobei die Leitungsträgerplatte eine erste Abmessung aufweist, die entlang der Längserstreckung der Tragevorrichtung (1) gemessen wird, und eine zweite Abmessung (9) aufweist, die in der Ebenen der Leitungsträgerplatte normal auf die erste Abmessung der Leitungsträgerplatte gemessen wird, wobei die zweite Abmessung der Leitungsträgerplatte 20% bis 40% der dazu korrespondierenden Abmessung (10) der ersten Begrenzungswand (2) entspricht.
Beispiel 4. Tragevorrichtung (1) nach einem der vorangehenden Beispiele, wobei der Leitungsträger (5) drei Stück der Leitungsbahnen (6) aufweist, die bevorzugt an einer einzigen Seitenfläche des Leitungsträgers (5) ausgebildet sind und/oder parallel zueinander entlang der Längserstreckung der Tragevorrichtung (1) verlaufen.
Beispiel 5. Tragevorrichtung (1) nach einem der vorangehenden Beispiele, wobei die Leitungsbahnen (6) als Drähte ausgeführt sind, die teilweise über die Außenfläche des Leitungsträgers (5) hervorragen.
Beispiel 6. Tragevorrichtung (1) nach einem der vorangehenden Beispiele, wobei die Leitungsbahnen (6) an jener der ersten Begrenzungswand (2) zugewandten Seite des Leitungsträgers (5) angeordnet sind.
Beispiel 7. Tragevorrichtung (1) nach einem der vorangehenden Beispiele, wobei die zweite Begrenzungswand (3) einen Aufnahme-Schacht (7) aufweist, der zur Aufnahme, insbesondere zur seitlich einschiebbaren Aufnahme, des Leitungsträgers (5) vorgesehen ist, und der Leitungsträger (5) eine zu der Form des Aufnahmeschachts korrespondierende Form, insbesondere eine T-Form oder eine am Kopf stehende L-Form, aufweist und in den Aufnahme-Schacht (7) eingesetzt ist.
Beispiel 8. Tragevorrichtung (1) nach einem der vorangehenden Beispiele, wobei die zweite Begrenzungswand (3) einen Unterstützungssteg (11) aufweist, der sich im Wesentlichen entlang des Leitungsträgers (5) erstreckt und diesen mechanisch unterstützt.
Beispiel 9. Tragevorrichtung (1) nach einem der vorangehenden Beispiele, wobei der Leitungsträger (5) aus Kunststoff gefertigt ist.
Beispiel 10. Tragevorrichtung (1) nach einem der vorangehenden Beispiele, wobei die erste Begrenzungswand (2) und die zweite Begrenzungswand (3), insbesondere auch der Unterstützungssteg (11) gemäß Beispiel 7, einteilig ausgebildet sind, insbesondere aus Stahl gefertigt sind.
Beispiel 11. Tragevorrichtung (1) nach einem der vorangehenden Beispiele, wobei die erste Begrenzungswand (2) entlang ihrer Längserstreckung im Raster angeordnete Ausnehmungen (13), insbesondere die erste Begrenzungswand (2) durchdringende Öffnungen, aufweist, die zur form- und/oder kraftschlüssigen Kopplung mit Befestigungsmitteln eines elektronischen Geräts bestimmt sind.
Beispiel 12. Tragevorrichtung (1) nach einem der vorangehenden Beispiele, wobei in Bezug auf jene Seite der ersten Begrenzungswand (2), die hin zum Aufnahmebereich (4) orientiert ist, zwischen der ersten Begrenzungswand (2) und der zweiten Begrenzungswand (3) ein spitzer Winkel (8), insbesondere ein Winkel in einem Bereich von 65° bis 85°, ausgebildet ist.
Beispiel 13. Tragevorrichtung (1) nach einem der vorangehenden Beispiele, wobei die zweite Begrenzungswand (3) einen entlang der Längserstreckung verlaufenden Randbereich (12) aufweist, der hin zu dem Aufnahmebereich (4) orientiert ist, bevorzugt nasen- bzw. hakenförmig ausgebildet ist, besonders bevorzugt gekrümmt ausgebildet ist.
Beispiel 14. Tragevorrichtung (1) nach einem der vorangehenden Beispiele, die einen Seitenabschnitt aufweist, der zur Aufnahme einer Versorgungseinrichtung (40) zur elektrischen Versorgung eines durch die Tragevorrichtung (1) tragbaren elektronischen Geräts (20), ausgebildet bzw. vorgesehen ist.
Beispiel 15. Tragevorrichtung (1) nach einem der vorangehenden Beispiele, wobei die erste Begrenzungswand (2), insbesondere in einem durch den Leitungsträger (5) überspannten Bereich, eine Struktur aus Begrenzungswand-Rippen (56) und dazwischen liegenden Begrenzungswand-Schluchten (57) aufweist, die zum Zusammenwirken mit einer Struktur von Gehäuse-Rippen (54) und dazwischen liegenden Gehäuse-Schluchten (55) des Gehäuses (21) des Geräts (20) zwecks Herstellung einer Sollorientierung des elektronischen Geräts (20) bei einem bestimmungsgemäßen Einsetzen des elektronischen Geräts (20) in die Tragevorrichtung (1) vorgesehen sind.
Beispiel 16. Versorgungseinrichtung (40) für eine Tragevorrichtung (1), insbesondere realisiert als Regalschiene, zur elektrischen Versorgung eines durch die Tragevorrichtung (1) tragbaren elektronischen Geräts (20), besonders bevorzugt einer elektronischen Anzeigeeinheit (20),
   wobei die Versorgungseinrichtung (40) derart ausgebildet ist, dass sie mit einem Seiten- bzw. Endabschnitt der Tragevorrichtung (1), welcher Seiten- bzw. Endabschnitt zur Aufnahme der Versorgungseinrichtung (40) ausgebildet bzw. vorgesehen ist, koppelbar ist,
   wobei die Versorgungseinrichtung (40) aufweist:
      - eine Versorgungselektronik (42) und
      - mit der Versorgungselektronik (42) verbundene Kontakte (44) zum Herstellen einer elektrisch leitfähigen Verbindung mit auf einem Leitungsträger (5) der Tragevorrichtung (1) angeordneten Leitungsbahnen (6),
   dadurch gekennzeichnet,
   dass die Kontakte (44) durch eine erste Gruppe metallischer Kontaktbänder (44) realisiert sind, wobei jedes Kontaktband (44) einen ersten Abschnitt, bevorzugt ersten Endabschnitt (45), aufweist, welcher erster Abschnitt (45) mit der Versorgungselektronik (42) verbunden ist, und einen zweiten Abschnitt, bevorzugt zweiten Endabschnitt (46), aufweist, welcher zweite Abschnitt (46) zur Kontaktierung der Leitungsbahnen (6) des Leitungsträgers (5) bestimmt ist, und wobei jedes Kontaktband (44) gekrümmt oder gewinkelt, bevorzugt zumindest L-Förmig, besonders bevorzugt U-Förmig, ausgebildet ist.
Beispiel 17. Versorgungseinrichtung (40) nach Beispiel 16, wobei jedes Kontaktband (44) an seinem zweiten Abschnitt (46) eine Bogenform (47) aufweist, die für den direkten Kontakt mit einer der Leitungsbahnen (6) vorgesehen ist.
Beispiel 18. Versorgungseinrichtung (40) nach einem der vorangehenden Beispiele 16-17, die ein Gehäuseteil (41) aufweist, das zumindest einseitig offen ist, sodass der Leitungsträger (5) an der offenen Gehäuseseite einführbar ist, wobei das Gehäuseteil (41) derart geformt ist, dass die zweiten Abschnitte (46) der Kontaktbänder (44) und der damit kontaktierbare Teil des Leitungsträger (5) umfasst sind.
Beispiel 19. Elektronisches Gerät (20), insbesondere Elektronische Anzeigeeinheit (20), das ein Gehäuse (21) mit einer Rückwand (22), einer Frontwand (23), insbesondere mit einem Bildschirm (24), und einer zwischen der Rückwand (22) und der Frontwand (23) verlaufenden Seitenwand (25) aufweist, wobei die Seitenwand (25) eine im Wesentlichen parallel zur Rückwand (22) verlaufende Leitungsträger-Nut (26) aufweist, die zur Aufnahme eines Leitungsträgers (5) einer Tragevorrichtung (1) bestimmt ist, wobei der Leitungsträger (5) Leitungsbahnen (6) zur elektronischen Versorgung des elektronischen Geräts (20), insbesondere der Anzeigeeinheit (20), aufweist.
Beispiel 20. Elektronisches Gerät (20) nach Beispiel 19, das Kontakte (27) zur Herstellung einer elektrisch leitfähigen Verbindung mit den Leitungsbahnen (6) des Leitungsträgers (5) aufweist, wobei jener Gehäuseteil, der die Leitungsträger-Nut (26) bildet, erste Gehäuseöffnungen aufweist, durch die hindurch die Kontakte (27) aus dem Gehäuse (21) herausragen.
Beispiel 21. Elektronisches Gerät (20) nach Beispiel 20, wobei die ersten Gehäuseöffnungen an jener Seite der Leitungsträger-Nut (26) realisiert sind, die der Rückwand (22) am nächsten ist.
Beispiel 22. Elektronisches Gerät (20) nach einem der Beispiele 20-21, wobei jeweils eine der Gehäuseöffnungen zur Position von genau einer der Leitungsbahnen (6) korrespondiert, wenn der Leitungsträger (5) bestimmungsgemäß in die Leitungsträger-Nut (26) eingesetzt ist.
Beispiel 23. Elektronisches Gerät (20) nach einem der Beispiele 20-22, wobei das elektronische Gerät (20) eine Gerät-Elektronik (29) aufweist und wobei die Kontakte (27) als eine zweite Gruppe metallischer Kontaktbänder (27) realisiert sind, wobei jedes Kontaktband (27) einen ersten Abschnitt, bevorzugt ersten Endabschnitt (28), aufweist, welcher erste Abschnitt (28) mit der Gerät-Elektronik (29) verbunden ist, und einen zweiten Abschnitt, bevorzugt zweiten Endabschnitt (30), aufweist, welcher zweite Abschnitt (30) zur Kontaktierung der Leitungsbahnen (6) des Leitungsträgers (5) bestimmt ist, wobei die zweite Gruppe metallischer Kontaktbänder (27) als Federelemente ausgeführt sind, wobei bevorzugt jedes Kontaktband (27) gekrümmt oder gewinkelt, insbesondere stufenförmig, ausgebildet ist.
Beispiel 24. Elektronisches Gerät (20) nach Beispiel 23, wobei jedes Kontaktband (27) an seinem zweiten Abschnitt (30) eine erhabene Form (31) aufweist, die für den direkten Kontakt mit einer der Leitungsbahnen (6) vorgesehen ist, und zumindest die erhabene Form (31) des Kontaktbands (27) an der zugeordneten Gehäuseöffnung aus dem Gehäuse (21) austritt und in den durch die Leitungsträger-Nut (26) begrenzten Raumbereich hineinragt.
Beispiel 25. Elektronisches Gerät (20), nach einem der Beispiele 19-24 das an der Rückwand (22) Befestigung-Gehäuseöffnungen aufweist und die einen, bevorzugt manuell, betätigbaren Befestigungsmechanismus (32) aufweist, wobei der Befestigungsmechanismus (32) zumindest zwei bewegliche Befestigung-Haken oder -Nasen (33) aufweist, die im unbetätigten Zustand durch die Befestigung-Gehäuseöffnung herausragen und bei Betätigung des Befestigungsmechanismus (32) ihre Position verändern.
Beispiel 26. Elektronisches Gerät (20) nach Beispiel 25, wobei der Befestigungsmechanismus (32) einen manuell betätigbaren Knopf (34) aufweist, der mit den Befestigung-Haken oder -Nasen (33) gekoppelt ist, bevorzugt mit den Befestigung-Haken oder -Nasen (33) einteilig ausgebildet ist, und der an jener der Längsträger-Nut (26) gegenüberliegenden Seitenwand (25) frei zugänglich ist.
Beispiel 27. Elektronisches Gerät (20), nach Beispiel 26, wobei der Befestigungsmechanismus (32) ein Befestigungsmechanismus-Federelement (35) aufweist, das den Knopf (34) im unbetätigten Zustand in einer ersten Position hält.
Beispiel 28. Elektronisches Gerät (20) nach einem der vorangehenden Beispiele 19-27, wobei an dem Gehäuse (21) eine Struktur aus Gehäuse-Rippen (54) und dazwischen liegenden Gehäuse-Schluchten (55) ausgebildet sind, die zum Zusammenwirken mit Begrenzungswand-Rippen (56) und dazwischen liegenden Begrenzungswand-Schluchten (57) der ersten Begrenzungswand (2) zwecks Herstellung einer Sollorientierung des elektronischen Geräts (20) bei einem bestimmungsgemäßen Einsetzen des elektronischen Geräts (20) in die Tragevorrichtung (1) vorgesehen sind.
Beispiel 29. System, das zumindest eine erfindungsgemäße Tragevorrichtung (1) nach einem der Beispiele 1-15, eine damit gekoppelte Versorgungseinrichtung (40) gemäß einem der Beispiele 16-18 und zumindest ein durch die Tragevorrichtung (1) getragenes elektronisches Gerät (20), insbesondere elektronische Anzeigevorrichtung (20), gemäß einem der Beispiele 19 - 28 aufweist.

## Patentansprüche

1. Tragevorrichtung (1) für die mechanische Befestigung einer elektronischen Anzeigeeinheit (20), wobei die Tragevorrichtung (1) aufweist:
eine erste Begrenzungswand (2) an der die elektronische Anzeigeeinheit (20) an der Tragevorrichtung (1) positionierbar ist,
eine in einem Winkel (8) zu der ersten Begrenzungswand (2) orientierte zweite Begrenzungswand (3), wobei die erste Begrenzungswand (2) und die zweite Begrenzungswand (3) einen Aufnahmebereich (4) für die Aufnahme der elektronischen Anzeigeeinheit (20) begrenzen, und
einen Leitungsträger (5), der Leitungsbahnen (6) zur elektronischen Versorgung der elektronischen Anzeigeeinheit (20) trägt, wobei der Leitungsträger (5) in einem Abstand von der ersten Begrenzungswand (2) ausgehend von der zweiten Begrenzungswand (3) in den Aufnahmebereich (4) hineinragt.

2. Tragevorrichtung (1) nach Anspruch 1, wobei der Leitungsträger (5) als Leitungsträgerplatte ausgebildet ist.

3. Tragevorrichtung (1) nach Anspruch 1 oder 2, wobei der Leitungsträger (5) mehrere Leitungsbahnen (6) für die signaltechnische Versorgung und für die Leistungsversorgung aufweisen.

4. Tragevorrichtung (1) nach einem der vorangehenden Ansprüche, wobei der Leitungsträger (5) drei Leitungsbahnen (6) aufweist.

5. Tragevorrichtung (1) nach einem der vorangehenden Ansprüche, die an einer einzigen Seitenfläche des Leitungsträgers (5) ausgebildet sind und/oder parallel zueinander entlang der Längserstreckung der Tragevorrichtung (1) verlaufen.

6. Tragevorrichtung (1) nach einem der vorangehenden Ansprüche, wobei die Leitungsbahnen (6) an jener der ersten Begrenzungswand (2) zugewandten Seite des Leitungsträgers (5) angeordnet sind.

7. Tragevorrichtung (1) nach einem der vorangehenden Ansprüche, wobei die erste Begrenzungswand (2) und die zweite Begrenzungswand (3) einteilig ausgebildet sind, insbesondere aus Stahl gefertigt sind.

8. Tragevorrichtung (1) nach einem der vorangehenden Ansprüche, wobei in Bezug auf jene Seite der ersten Begrenzungswand (2), die hin zum Aufnahmebereich (4) orientiert ist, zwischen der ersten Begrenzungswand (2) und der zweiten Begrenzungswand (3) ein spitzer Winkel (8) ausgebildet ist.

9. Tragevorrichtung (1) nach einem der vorangehenden Ansprüche, die einen Seitenabschnitt aufweist, der zur Aufnahme einer Versorgungseinrichtung (40) zur elektrischen Versorgung eines durch die Tragevorrichtung (1) tragbaren elektronischen Anzeigeeinheit (20) vorgesehen ist.

10. Versorgungseinrichtung (40) für die Tragevorrichtung (1) nach einem der vorangehenden Ansprüche, wobei die Versorgungseinrichtung (40) aufweist:
eine Versorgungselektronik (42) und
mit der Versorgungselektronik (42) verbundene Kontakte (44) zum Herstellen einer elektrisch leitfähigen Verbindung mit auf einem Leitungsträger (5) der Tragevorrichtung (1) angeordneten Leitungsbahnen (6).

11. Elektronische Anzeigeeinheit (20) für die Tragevorrichtung (1) nach einem der Ansprüche 1 bis 9, die ein Gehäuse (21) mit einer Rückwand (22), einer Frontwand (23) mit einem Bildschirm (24), und einer zwischen der Rückwand (22) und der Frontwand (23) verlaufenden Seitenwand (25) aufweist.

12. Elektronische Anzeigeeinheit (20) nach Anspruch 11, wobei die Seitenwand (25) eine im Wesentlichen parallel zur Rückwand (22) verlaufende Leitungsträger-Nut (26) aufweist, die zur Aufnahme eines Leitungsträgers (5) der Tragevorrichtung (1) bestimmt ist, wobei der Leitungsträger (5) Leitungsbahnen (6) zur elektronischen Versorgung der Anzeigeeinheit (20), aufweist.

13. Elektronische Anzeigeeinheit (20) nach Anspruch 11 oder 12, wobei die Frontwand (23) an ihrem oberen Ende eine Stufe aufweist, die zur Aufnahme eines Randbereichs (12) der Tragevorrichtung (1) ausgebildet ist.

14. Elektronische Anzeigeeinheit (20) nach einem der Ansprüche 11 bis 13, das Kontakte (27) zur Herstellung einer elektrisch leitfähigen Verbindung mit den Leitungsbahnen (6) des Leitungsträgers (5) aufweist, wobei jener Gehäuseteil, der die Leitungsträger-Nut (26) bildet, erste Gehäuseöffnungen aufweist, durch die hindurch die Kontakte (27) aus dem Gehäuse (21) herausragen, wobei vorzugsweise die ersten Gehäuseöffnungen an jener Seite der Leitungsträger-Nut (26) realisiert sind, die der Rückwand (22) am nächsten ist.

15. System, das die Tragevorrichtung (1) nach einem der Ansprüche 1 bis 9, die damit gekoppelte Versorgungseinrichtung (40) nach Anspruch 10 und zumindest eine durch die Tragevorrichtung (1) getragene elektronische Anzeigeeinheit (20) nach einem der Ansprüche 11 bis 14 aufweist.
